(19) Europäisches Patentamt
European Patent Office
Office européen des brevets

(11) EP 4 656 687 A1

(12) **EUROPEAN PATENT APPLICATION**
published in accordance with Art. 153(4) EPC

(43) Date of publication:
**03.12.2025 Bulletin 2025/49**

(21) Application number: **24747376.2**

(22) Date of filing: **26.01.2024**

(51) International Patent Classification (IPC):
***C08L 101/00*** (2006.01) ***C08K 3/04*** (2006.01)
***C08K 3/013*** (2018.01) ***C08K 3/22*** (2006.01)
***C08K 3/28*** (2006.01) ***C08K 5/54*** (2006.01)
***C08K 7/18*** (2006.01) ***C08L 33/00*** (2006.01)
***C08L 63/00*** (2006.01) ***C08L 83/04*** (2006.01)
***C09K 5/14*** (2006.01)

(52) Cooperative Patent Classification (CPC):
**C08K 3/013; C08K 3/04; C08K 3/22; C08K 3/28; C08K 5/54; C08K 7/18; C08L 33/00; C08L 63/00; C08L 83/04; C08L 101/00; C09K 5/14**

(86) International application number:
**PCT/JP2024/002455**

(87) International publication number:
**WO 2024/158052 (02.08.2024 Gazette 2024/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.01.2023 JP 2023011404**

(71) Applicant: **Sekisui Chemical Co., Ltd.**
**Osaka-shi, Osaka 530-8565 (JP)**

(72) Inventors:
- **URAYAMA, Takahiro**
  **Mishima-gun, Osaka 618-0021 (JP)**
- **TAKAHASHI, Ryousuke**
  **Mishima-gun, Osaka 618-0021 (JP)**
- **INUI, Osamu**
  **Mishima-gun, Osaka 618-0021 (JP)**
- **NISHIZAWA, Hidehito**
  **Mishima-gun, Osaka 618-0021 (JP)**
- **ASANO, Motohiko**
  **Mishima-gun, Osaka 618-0021 (JP)**
- **YOSHIOKA, Tetsuro**
  **Mishima-gun, Osaka 618-0021 (JP)**
- **KAGE, Yuuto**
  **Mishima-gun, Osaka 618-0021 (JP)**

(74) Representative: **Ter Meer Steinmeister & Partner**
**Patentanwälte mbB**
**Nymphenburger Straße 4**
**80335 München (DE)**

(54) **RESIN COMPOSITION AND HEAT-DISSIPATING MEMBER**

(57) There is provided a resin composition containing a first filler that is at least one selected from the group consisting of octahedral diamond and hexoctahedral diamond, a second filler different from the first filler, and a matrix resin, wherein the volume-average particle diameter for primary particle diameter of the first filler is larger than the volume-average particle diameter for primary particle diameter of the second filler; the volume percentage of the whole of the fillers is higher than 80% by volume, and the volume percentage of the diamond is higher than 20% by volume; and the volume-average particle diameter for primary particle diameter of the first filler is 55 μm or larger.

EP 4 656 687 A1

## Description

### Technical Field

The present invention relates to a heat-dissipating member to be used in electronic devices or the like, and a resin composition for forming the heat-dissipating member or the like.

### Background Art

In electronic devises, since integrated electronic components generate heat, which causes failures, there are sometimes installed heat-dissipating members for dissipating heat generated by the electronic components outside the devices. In recent years, amid evolvement of performance enhancement and size reduction of electronic components, the heat countermeasures to exhibit and retain the performance of the electronic components in themselves increasingly become important. With regard to heat-dissipating members, high heat-dissipating compounds having high heat dissipation properties are demanded.

A high heat-dissipating compound is constituted of a matrix resin and a high heat-dissipating filler, but in order to enhance the heat dissipation properties of the compound, the resin higher in the thermal conductivity and the dense filling of the filler are demanded. Along with the dense filling of the filler, however, since the flowability of the compound is lost and the workability reduces, the fabrication of a compound dense in filling and high in flowability is demanded.

As a high heat-dissipating compound, for example, a compound using aluminum nitride as a filler high in the thermal conductivity is reported in Patent Literature 1. In Patent Literature 1, by using aluminum nitride and optimizing a resin composition, the attainment of both of the dischargeability and the thermal conductivity is attempted. Then, in Patent Literature 2, it is reported that use of diamond as a filler high in the thermal conductivity can make a resin composition high in the thermal conductivity.

### Citation List

#### Patent Literature

PTL1: JP7039157B
PTL2: WO2019/230969A

### Summary of Invention

#### Technical Problem

Conventional heat-dissipating compounds, however, cannot make both of the heat dissipation performance and the flowability to be sufficiently high.

Then, the present invention has an object to provide a resin composition and a heat-dissipating member which can attain both of the heat dissipation performance and the flowability.

#### Solution to Problem

As a result of exhaustive studies, the present inventors have found that in order to attain both of the heat dissipation performance and the flowability, it is necessary to use a first filler composed of at least either of an octahedral diamond and an hexoctahedral diamond, and a second filler different from the first filler. Then, it has been found that by regulating the volume-average particle diameter for primary particle diameter of the fillers so as to meet a predetermined requirement, and making also the volume percentage of the fillers to be a predetermined value or higher, a compound which causes diamond to fully exhibit slidability and has high flowability even in dense filling can be fabricated, and this finding has led to the completion of the following present invention.

The present invention provides the following [1] to [16].

[1] A resin composition, comprising:

a first filler that is at least one selected from the group consisting of octahedral diamond and hexoctahedral diamond;

a second filler different from the first filler; and
a matrix resin,
the volume-average particle diameter for primary particle diameter of the first filler being larger than the volume-average particle diameter for primary particle diameter of the second filler;
a volume percentage of a whole of fillers therein being higher than 80% by volume, and the volume percentage of diamond therein being higher than 20% by volume; and
the volume-average particle diameter for primary particle diameter of the first filler being 55 μm or larger.

[2] The resin composition according to the above [1], wherein the second filler comprises at least one selected from the group consisting of nitrides and metal oxides.
[3] The resin composition according to the above [1] or [2], wherein the second filler comprises at least one selected from the group consisting of aluminum oxide and aluminum nitride.
[4] The resin composition according to the above [3], wherein the second filler comprises aluminum nitride.
[5] The resin composition according to any one of the above [1] to [4], wherein the ratio of the volume-average particle diameter for primary particle diameter of the second filler to the volume-average particle diameter for primary particle diameter of the first filler is 0.005 or higher and 0.5 or lower.
[6] The resin composition according to any one of the above [1] to [5], wherein the second filler comprises at least a filler having a sphericity of 0.7 or higher.
[7] The resin composition according to any one of the above [1] to [6], wherein the volume percentage of the whole of the fillers therein is 85% by volume or higher.
[8] The resin composition according to any one of the above [1] to [7], wherein the volume percentage of the diamond therein is 20% by volume or higher and 70% by volume or lower.
[9] The resin composition according to any one of the above [1] to [8], wherein the volume percentage of the diamond therein is 30% by volume or higher and 65% by volume or lower.
[10] The resin composition according to any one of the above [1] to [9], wherein the matrix resin is at least one selected from the group consisting of a silicone resin, an epoxy resin and an acrylic resin.
[11] The resin composition according to any one of the above [1] to [10], further comprising a dispersant.
[12] The resin composition according to the above [11], wherein the dispersant is a silicone compound having a polar group on an end or a side chain thereof.
[13] The resin composition according to the above [12], wherein the silicone compound has at least either of an alkoxy group and a hydroxyl group on an end thereof.
[14] The resin composition according to any one of the above [1] to [13], wherein the resin composition has a viscosity at 25°C of 700 Pa·s or lower and a thermal conductivity of 10 W/(m·K) or higher.
[15] A heat-dissipating member, being formed of the resin composition according to any one of the above [1] to [14].
[16] An electronic device, comprising an electronic component, and the heat-dissipating member according to the above [15] disposed on the electronic component.

Advantageous Effects of Invention

According to the present invention, there can be provided a resin composition and a heat-dissipating member which can attain both of the heat dissipation property and the flowability.

Description of Embodiments

Hereinafter, the present invention will be described by way of embodiments.

[Resin composition]

The resin composition of the present invention contains a first filler that is at least one selected from the group consisting of octahedral diamond and hexoctahedral diamond, a second filler different from the first filler, and a matrix resin. Hereinafter, each component will be described in detail.

[First filler]

In the present invention, the first filler to be contained in the resin composition is an octahedral diamond, an hexoctahedral diamond, or both thereof. The octahedral diamond and the hexoctahedral diamond are typically synthetic diamonds, and are synthesized preferably by a high-temperature high-pressure process. The octahedral diamond and the hexoctahedral diamond can easily be produced by being synthesized by the high-temperature high-pressure process, and

can have a relatively large particle diameter.

The octahedral diamond and the hexoctahedral diamond are also called as-grown particles and are crystalline diamond particles not having been crushed and retaining the shape in the synthesis. Since the octahedral diamond and the hexoctahedral diamond make low the friction coefficient between diamond particles and make good the slidability therebetween, as described later, even when the volume percentage of the fillers or the volume percentage of the diamond particles are made high, the flowability of the resin composition becomes good. Further since the diamond particles are high in thermal conductivity, it becomes easy for the heat dissipation property of the resin composition to be made good.

The first filler has a volume-average particle diameter for primary particle diameter of 55 μm or larger. When the volume-average particle diameter for primary particle diameter is smaller than 55 μm, it becomes difficult for both of the heat dissipation property and the flowability of the resin composition to be made good.

The volume-average particle diameter for primary particle diameter of the first filler is preferably 57 μm or larger, more preferably 59 μm or larger and still more preferably 62 μm or larger. Then, the volume-average particle diameter for primary particle diameter of the first filler is not especially limited, but is, for example, 300 μm or smaller, and preferably 200 μm or smaller, more preferably 150 μm or smaller and still more preferably 100 μm or smaller. Due to that the first filler has a volume-average particle diameter for primary particle diameter of a certain value or smaller, a heat-dissipating compound, when being mounted on an electronic member, can be reduced in film thickness. Then, it becomes easy for the fillers to be suitably held in the matrix resin, and further, the formation of irregularities on a heat-dissipating member or the like formed of the resin composition due to the first filler can be prevented.

The first filler has a larger volume-average particle diameter for primary particle diameter than the volume-average particle diameter for primary particle diameters of the second filler. When the first filler has a volume-average particle diameter for primary particle diameter equal to or smaller than that of the second filler, the first filler ends in being smaller than necessary and the second filler ends in being larger than necessary, and filling the matrix resin with the fillers becomes difficult, making difficult the attainment of both of the heat dissipation property and the flowability.

Then, the ratio (second filler/first filler) of the volume-average particle diameter for primary particle diameter of the second filler to the volume-average particle diameter for primary particle diameter of the first filler is preferably 0.005 or higher and 0.5 or lower. Due to that the (second filler/first filler) is in the above range, it becomes easy for gaps between the first fillers to be filled with the second filler, and it becomes easy for the volume percentage of each filler to be raised. The ratio (second filler/first filler) is more preferably 0.015 or higher, still more preferably 0.03 or higher and further still more preferably 0.05 or higher. Then, the ratio (second filler/first filler) is more preferably 0.4 or lower, still more preferably 0.3 or lower and further still more preferably 0.20 or lower.

Here, the volume-average particle diameter for primary particle diameter can be determined by measuring a 50% particle diameter (D50) in a cumulative particle size distribution in terms of volume of the primary particles. Then, the cumulative particle size distribution in terms of volume can be determined by using a laser diffraction/scattering particle size distribution analyzer. The laser diffraction/scattering particle size distribution analyzer includes "MT3300EXII", manufactured by MicrotracBEL Corp. Here, the volume-average particle diameter of the first filler, also in the case where the first filler is constituted of two or more fillers, may be determined as an average value for all the fillers constituting the first filler. The same applies also to the second filler.

The first filler may be used singly in one kind thereof, or may be used concurrently in two or more kinds thereof.

[Second filler]

The second filler is a filler different from the above first filler. Therefore, the second filler is a filler other than the octahedral diamond and the hexoctahedral diamond. The second filler is preferably a thermal conductive filler; and the thermal conductivity of the second filler is, from the viewpoint of enhancing the thermal conductivity, preferably 8 W/(m·K) or higher, more preferably 20 W/(m·K) or higher and still more preferably 30 W/(m·K) or higher. The upper limit of the thermal conductivity is not especially limited, and is, for example, 2,500 W/(m·K). Then, the thermal conductivity can be measured, for example, by a periodic heating thermoreflectance method using a thermal microscope, manufactured by Bethel Co. Ltd., and involving measurement on a particle cross-section cut by a Cross Section Polisher.

The second filler includes metals, carbides, nitrides, oxides, hydroxides, carbonaceous materials other than diamond, and diamond particles other than octahedral diamond and hexoctahedral diamond.

The metals include silver, copper, gold, aluminum, nickel, chromium, tin, lead, bismuth, zinc and the like. Examples of the carbides include silicon carbide, boron carbide, aluminum carbide, titanium carbide and tungsten carbide. Examples of the nitrides include silicon nitride, boron nitride, aluminum nitride, gallium nitride, chromium nitride, tungsten nitride, magnesium nitride, molybdenum nitride and lithium nitride. Examples of the oxides include metal oxides such as aluminum oxides like alumina and boehmite, zinc oxide, iron oxide, magnesium oxide, titanium oxide, cerium oxide and zirconium oxide, and silicon oxide (silica). Examples of the hydroxides include metal hydroxides such as aluminum hydroxide, calcium hydroxide and magnesium hydroxide. Examples of the carbonaceous materials include carbon black,

graphite, graphene, fullerene, carbon nanotubes and carbon nanofibers. The diamond particles other than octahedral diamond and hexoctahedral diamond include nanodiamonds and crushed diamonds obtained by crushing as-grown particles. As the second filler, talc being a silicate mineral, or the like is also usable.

The second filler preferably contains, among the above, at least either of metal oxides and nitrides; more preferably contains, among these, any one of zinc oxide, aluminum oxide and aluminum nitride; still more preferably contains either one of aluminum oxide and aluminum nitride; and further still more preferably contains at least aluminum nitride. Among these, since a metal nitride such as aluminum nitride or a metal oxide such as aluminum oxide is high in hardness and low in frictional coefficient, the slidability with the first filler being diamond particles becomes high, enhancing the flowability. In particular, since aluminum nitride is high in the thermal conductivity and additionally very low in sliding friction, the friction between the fillers becomes low, enhancing the flowability.

The shape of the second filler is not especially limited, and may be any of tabular, flaky, acicular, fibrous, tubular, globular, polyhedral and crushed shapes and the like.

Then, the second filler contains a filler having a sphericity of, for example, 0.5 or higher, preferably 0.6 or higher, more preferably 0.65 or higher, still more preferably 0.7 or higher. The nearer the sphericity is to 1, the nearer the shape is to a globular shape; by making the sphericity high, it becomes easy for gaps between the first filler to be filled and for the slidability of the filler to be enhanced, and it becomes easy for both of the flowability and the heat dissipation performance to be enhanced. The upper limit of the sphericity is not especially limited, and is 1.

In the case where the second filler contains a filler having a sphericity of 0.7 or higher, the proportion of the filler having a sphericity of 0.7 or higher may be, in terms of volume with respect to the whole second filler, for example, 0.1 or higher, and is preferably 0.2 or higher, more preferably 0.4 or higher and still more preferably 0.5 or higher. By making the high proportion of the filler having a sphericity of 0.7 or higher, it becomes easy for the slidability of the filler to be enhanced, and it becomes easy for both of the flowability and the heat dissipation performance to be enhanced. The higher the proportion of the filler having a sphericity of 0.7 or higher, the better; and the upper limit thereof is 1.

Here, the sphericity of each filler can be determined by examining an electron microscope photograph and calculating (the diameter of a circle whose area is equivalent to a projected area of a particle/the diameter of the smallest circle circumscribing a projected image of the particle) for each filler.

As described above, the volume-average particle diameter for primary particle diameter of the second filler should be smaller than that of the first filler. The volume-average particle diameter for primary particle diameter of the second filler suffices when being smaller than, for example, 95 μm, and is preferably smaller than 55 μm, more preferably 30 μm or smaller, still more preferably 20 μm or smaller and further still more preferably 15 μm or smaller. By making the small volume-average particle diameter for primary particle diameter of the second filler, since gaps between the first fillers can be filled, the filling fraction of the whole resin composition can be raised, and resultantly, it becomes easy for the heat dissipation performance to be enhanced.

The volume-average particle diameter for primary particle diameter of the second filler suffices when being, for example, 0.1 μm or larger, and is preferably 0.5 μm or larger, more preferably 1 μm or larger, still more preferably 2 μm or larger and further still more preferably 4 μm or larger. By making the volume-average particle diameter for primary particle diameter of the second filler to be a certain value or larger, even when the volume percentage of the second filler is made high, it becomes easy for the flowability of the resin composition to be made good.

The second filler may be used singly in one kind thereof, or may be used concurrently in two or more kinds thereof.

In the case of using two or more kinds, use of two or more kinds selected from metal oxides and nitrides is preferable; among these, use of two or more kinds selected from metal oxides and metal nitrides is more preferable; and specifically, concurrent use of aluminum oxide and aluminum nitride, or concurrent use of aluminum oxide and zinc oxide is still more preferable. Further, concurrent use of two or more kinds of fillers having different volume-average particle diameters for primary particle is also preferable.

[Volume percentage of the fillers]

The volume percentage of the whole of the fillers in the resin composition is 80% by volume or higher. When the volume percentage of the whole of the fillers becomes lower than 80% by volume, the heat dissipation performance cannot sufficiently be enhanced. The volume percentage of the whole of the fillers is, from the viewpoint of making the diamond to exhibit the sliding effect by making the fillers dense, and making it easy for both of the heat dissipation performance and the flowability to become excellent, preferably 82% by volume or higher and more preferably 85% by volume or higher. Further, in order to make the resin composition to contain the matrix resin and the like in a certain amount or more, the volume percentage of the whole of the fillers is preferably 95% by volume or lower, more preferably 93% by volume or lower, still more preferably 91% by volume or lower and further still more preferably 90% by volume or lower.

The volume percentage of the diamond in the resin composition is 20% by volume or higher. When the volume percentage of the diamond is lower than 20% by volume, it is difficult to attain both of the heat dissipation performance and the flowability of the resin composition. The volume percentage of the diamond is, from the viewpoint of making the sliding

effect of the diamond exhibited by making the fillers dense, and making it easy for both of the heat dissipation performance and the flowability to become excellent, preferably 25% by volume or higher, more preferably 30% by volume or higher and still more preferably 40% by volume or higher.

Then, the volume percentage of the diamond in the resin composition is preferably 70% by volume or lower, more preferably 65% by volume or lower and still more preferably 60% by volume or lower. By making the volume percentage of the diamond to be a certain value or lower, the diamond easily becomes compatible with the matrix resin and the diamond can easily be dispersed suitably in the resin.

Then, in the resin composition, diamond may be contained, in addition to the first filler (octahedral diamond and hexoctahedral diamond) as described above, as the second filler, but it is preferable that the diamond in the resin composition consists of the first filler.

Therefore, the volume percentage of the first filler in the resin composition is preferably 20% by volume or higher, more preferably 25% by volume or higher, still more preferably 30% by volume or higher and further still more preferably 40% by volume or higher. Then, the volume percentage of the first filler in the resin composition is preferably 70% by volume or lower, more preferably 65% by volume or lower and still more preferably 60% by volume or lower.

The volume percentage of the second filler in the resin composition is preferably 10% by volume or higher. When the volume percentage of the second filler is made to be 10% by volume or higher, the second filler sufficiently enters between the first fillers, making it easy for the heat dissipation performance to be enhanced. The volume percentage of the second filler is, from the viewpoint of more enhancing the heat dissipation performance, more preferably 15% by volume or higher, still more preferably 20% by volume or higher and further still more preferably 25% by volume or higher.

Then, the volume percentage of the second filler is preferably 75% by volume or lower, more preferably 65% by volume or lower and still more preferably 50% by volume or lower. By making the volume percentage of the second filler be a certain value or lower, it becomes easy for the fillers to be mixed with the resin and suitably dispersed in the resin.

In the case where the second filler contains aluminum nitride, the volume percentage of the aluminum nitride in the resin composition is preferably 5% by volume or higher. When the volume percentage of aluminum nitride is made to be 5% by volume or higher, while the heat dissipation performance of the resin composition is made good, it becomes easy for the flowability to be enhanced. The volume percentage of aluminum nitride in the resin composition is more preferably 8% by volume or higher and still more preferably 15% by volume or higher.

Then, the volume percentage of aluminum nitride is preferably 50% by volume or lower, more preferably 45% by volume or lower, still more preferably 35% by volume or lower and further still more preferably 30% by volume or lower. By making the volume percentage of the aluminum nitride be a certain value or lower, mixing of the resin and the fillers becomes easy and it becomes easy for the fillers to be suitably dispersed in the resin. Further, it becomes easy for the volume percentage of the diamond to be made to be a certain value or higher.

Here, in the present description, the "volume percentage" means % by volume with respect to the total volume of the resin composition, and for example, the volume percentage of the first filler means % by volume accounted for by the first filler with respect to the total volume of the resin composition. The volume of each component can be calculated by the weight and density of each component.

Furthermore, the volume percentage can also be determined, for example, by separating each component from the resin composition. Specifically, a solvent is suitably added to the resin composition to dissolve the matrix resin, or the matrix resin and additives such as the dispersant, and the matrix resin or the matrix resin and the additives such as the dispersant are separated from the fillers by a centrifugal separator or the like. Thereafter, the density and weight of the separated matrix resin or mixture of the matrix resin and additives such as the dispersant, and the volume of the matrix resin or the mixture of the matrix resin and the additives such as the dispersant is determined from the measurement values. Similarly, the density and weight of the separated fillers also are measured and the volume of the whole of the fillers is determined from the measurement values. Thereafter, by utilizing such a property that the diamond decomposes at a lower temperature than the other fillers, the whole of the fillers is fired to decompose only the diamond. Then, the density and weight of the remaining fillers other than the diamond are measured and the volume of the fillers other than the diamond is determined from the measurement values; and the volume of the diamond is determined from the volume of the fillers other than the diamond and the volume of the whole of the fillers.

From the volumes of the matrix resin, the mixture of the matrix resin and the additives such as the dispersant, the whole of the fillers, and the diamond, calculated as in the above, for example, the volume percentage of the whole of the fillers and the volume percentage of the diamond can be calculated.

The density of the separated matrix resin and the density of the separated fillers may be measured by a densitometer (for example, "AccuPyc II1340", manufactured by Shimadzu Corp.) at 23°C.

[Matrix resin]

The matrix resin is a resin component to hold the first filler and the second filler. The resin component may be a curable resin or may be a non-curable resin such as a thermoplastic resin. Further, the resin component may be an

elastomer resin. The curable resin may be any of moisture-curable resins, thermocurable resins and photocurable resins, but is preferably a thermocurable resin. The resin component is preferably a liquid component. The liquid resin component may be one which turns to a solid by being cured, or one which is non-curable and liquid as it is in a heat-dissipating member. Then, the liquid component is a component which is liquid at room temperature (25°C) and at atmospheric pressure (1 atm). Then, the matrix resin suffices when using a resin other than a compound to be used as the dispersant described later.

In the case of the curable resin, the resin component may be either of one-component curing type or a two-component curing type, but is preferably a two-component curing type. The two-component curing type one is used by mixing two components of a first component containing a base resin and a second component containing a curing agent. The two-component curing type may be cured by mixing the first liquid and the second liquid, for example, at room temperature.

Then, in the two-component curing type, the first component may be the resin composition of the present invention; the second component may be the resin composition of the present invention; or a mixture of the first component and the second component may be the resin composition of the present invention, but it is preferable that both of the first component and the second component are the resin composition of the present invention and the mixture thereof is also the resin composition of the present invention.

That is, in the case of the two-component curing type, it suffices when the resin composition of the present invention constitutes either one of the first component or the second component. Accordingly, it suffices when the resin composition contains either one of a resin component constituting a base resin or a resin component constituting a curing agent. Further, in the case where the resin composition of the present invention is a mixture of the two components of the two-component curing type, or in the case of the one-component type, it suffices when the resin composition of the present invention contains both of a resin component constituting a base resin and a resin component constituting a curing agent.

Also in the case where in the case of the two-component curing type, the resin composition constitutes either one of the first component or the second component, it is a matter of course that the resin composition may contain both of a resin component constituting a base resin and a resin component constituting a curing agent as long as the base resin and the curing agent does not react in storage.

Specific examples of the resin component constituting the matrix resin include silicone resins, epoxy resins, acrylic resins, urethane resins, phenol resins, unsaturated polyester resins, polyimide resins, polyolefin resins such as polypropylene resins, polyethylene resins, poly(1-)butene resins and polypentene resins, polyester resins such as polyethylene terephthalate, polystyrene resins, acrylonitrile-butadiene-styrene (ABS) resins, ethylene vinyl acetate copolymers (EVA), polyamide resins and polyvinyl chloride resins (PVC).

Then, the resin component may be an elastomer resin, which specifically includes acrylonitrile-butadiene rubber, ethylene-propylene-diene rubber, ethylene-propylene rubber, natural rubber, polybutadiene rubber, polyisoprene rubber, polyester-based thermoplastic elastomer, polyurethane-based thermoplastic elastomer, styrene-based thermoplastic elastomer and the like. The elastomer resin may be liquid or solid.

The resin component constituting the matrix resin may be used singly in one kind thereof, or may be used concurrently in two or more kinds thereof.

The resin component is, among in the above, preferably at least one selected from a silicone resin, an epoxy resin, an acrylic resin, polybutadiene rubber and a polyester resin; more preferably at least one selected from a silicone resin, an epoxy resin and an acrylic resin; and still more preferably a silicone resin. Due to that the silicone resins, since being hydrophobic, are easily compatible with the diamond surface having few functional groups, and the epoxy resins and the acrylic resins are compatible with the few functional groups present on the diamond surface, it becomes easy for the flowability of the resin composition to be enhanced.

(Silicone resin)

Specific examples of the silicone resins include curable silicone resins. The curable silicone resin may be either of a condensation-curable silicone resin or an addition reaction-curable silicone resin, but is preferably an addition reaction-curable silicone resin.

It is preferable that the curable silicone resin is composed of a silicone resin constituting a base resin and a silicone resin constituting a curing agent that cures the base resin. Then, in the case of the addition reaction-curing silicone resin, a silicone resin to be used as its base resin is preferably an organopolysiloxane having alkenyl groups. The organopolysiloxane having alkenyl groups is more preferably one having two or more alkenyl groups.

The alkenyl group is not especially limited, but examples thereof include ones having 2 to 8 carbon atoms, and include a vinyl group, an allyl group, a butenyl group, a pentenyl group, a hexenyl group, a heptenyl group and an octenyl group; and among these, from the viewpoint of easiness of synthesis and reactivity, and the like, a vinyl group is preferable. Then, the alkenyl group is desirably one bound directly to a silicon atom.

The organopolysiloxane having alkenyl groups specifically includes both-end vinyl-terminated organopolysiloxanes such as both-end vinyl-terminated polydimethylsiloxane, both-end vinyl-terminated polyphenylmethylsiloxane, both-end vinyl-terminated dimethylsiloxane-diphenylsiloxane copolymers, both-end vinyl-terminated dimethylsiloxane-phenylmethylsiloxane copolymers and both-end vinyl-terminated dimethylsiloxane-diethylsiloxane copolymers.

The silicone resin as the curing agent to be used for the addition reaction-curable silicone resin is not especially limited as long as being able to cure the above-mentioned silicone resin as the base resin, but is an organopolysiloxane having hydrosilyl groups (SiH). Organohydrogenpolysiloxane is preferable. It is preferable that the organohydrogenpolysiloxane has two or more hydrosilyl groups.

In the resin composition, the ratio (molar ratio) of the hydrosilyl group to the alkenyl group of the silicone resin as the base resin is preferably 0.3 or higher and 5 or lower, more preferably 0.4 or higher and 4 or lower and still more preferably 0.6 or higher and 4 or lower. In the resin composition containing the diamond, though the reaction of the base resin and the curing agent does not proceed due to the diamond in some cases, when the molar ratio is 0.6 or higher, the reaction proceeds sufficiently and it becomes possible that a fully cured heat-dissipating member is obtained. Then, in the case where the resin composition is a one-component curing type, in the case where the resin composition is a two-component type and is a mixture of its first component and its second component, or the like, it is preferable that the above-mentioned ratio (molar ratio) of a hydrosilyl group to an alkenyl group is in the above range in the resin composition.

The organohydrogenpolysiloxane includes methyhydrosiloxane-dimethylsiloxane copolymers, polymethylhydrosiloxane, polyethylhydrosiloxane and methylhydrosiloxane-phenylmethylsiloxane copolymers. These may have a hydrosilyl group on their end, or may have no hydrosilyl group thereon.

The silicone resin may be, for example, a silicone oil. The silicone oil includes methylphenylsilicone oil, dimethylsilicone oil and modified silicone oil.

The silicone oil is liquid at room temperature and atmospheric pressure when blending, and is a liquid or gelatinous component when using. That is, the silicone oil is not cured with a curing agent or the like, and even when being cured, after being cured, is liquid or gelatinous, that is, substantially non-curable. Therefore, when the silicone oil is used, as the resin component, singly or in a relatively high blending proportion, it becomes possible to make a heat-dissipating member formed of the resin composition pasty.

The silicone resin contained in the resin composition has a viscosity at 25°C of preferably 5 mPa·s or higher and 1,000 mPa·s or lower, more preferably 30 mPa·s or higher and 700 mPa·s or lower, and still more preferably 50 mPa·s or higher and 600 mPa·s or lower.

Here, the viscosity of the silicone resin may be measured by using a viscometer (BROOKFIELD rotational viscometer DV-E) and using a rotator of Spindle No. 14 at a rotation speed of 5 rpm at a measurement temperature of 25°C.

When the viscosity range of the silicone resin is made to be in the above range, since the viscosity of the resin composition is made to be in a predetermined range and the coatability of the resin composition is made good and simultaneously, the resin composition after being coated can be held in a certain shape, the resin composition becomes enabled to be easily disposed on an electronic component or the like. Further, it becomes easy for a filler such as the diamond to be blended in a large amount while the filler is suitably dispersed.

Then, in the case where the resin composition is a two-component curing type and constitutes either of its first component or its second component, it suffices when the resin composition contains either of the silicone resin to become the base resin or the silicone resin to become the curing agent as described above. More specifically, it is preferable that the resin composition contains either of organopolysiloxane having alkenyl groups or organohydrogenpolysiloxane.

Even in the case of constituting either of the first component or the second component of the two-component curing type, however, as far as curing does not proceed, the silicone resin may contain organohydrogenpolysiloxane or organopolysiloxane having alkenyl groups in addition to the organopolysiloxane having alkenyl groups or organohydrogenpolysiloxane.

In the case where the resin composition is a one-component curing type, and in the case where the resin composition, even when being a two-component curing type, is a mixture of its first component and its second component, the resin composition may contain both of the silicone resin to become the base resin and the silicone resin to become the curing agent. That is, in the case where the resin composition is a one-component curing type, and in the case where the resin composition, even when being a two-component curing type, is a mixture of its first component and its second component, it is preferable that the resin composition contain both of organopolysiloxane having alkenyl groups and organohydrogenpolysiloxane.

The curing type resin composition may contain, as the silicone resin, a non-curable organopolysiloxane, and may contain, for example, in addition to the above-mentioned organopolysiloxane having alkenyl groups or the organopolysiloxane having hydrosilyl groups, silicone oil and the like. The resin composition, of course, may be a non-curing type silicone resin composition, and in such a case, as the silicone resin, for example, a silicone oil may be used singly.

(Epoxy resin)

As the epoxy resin to be used as the resin component, it is preferable to use an epoxy compound having at least

one epoxy group, preferably two or more epoxy groups. The epoxy compound is a curable resin, and is usually a thermocurable resin.

Examples of the epoxy compound include bisphenol type, novolac type, naphthalene type, triphenolalkane type, biphenyl type, aliphatic type, and alicyclic type ones, and halides of these, and hydrogenated compounds of these.

Then, as the epoxy resin, an epoxy compound is allowed to be used singly, but an epoxy resin having the above epoxy compound as its base resin and a curing agent added thereto is used. As the curing agent, a polyaddition type one or a catalyst type one is used. Examples of the polyaddition type curing agent include polyamine-based curing agents, acid anhydride-based curing agents, polyphenol-based curing agents, polymercaptane and dicyandiamide. Examples of the above catalyst type curing agent include tertiary amines, imidazoles and Lewis acid complexes. These may be used singly in one kind, or may be used concurrently in two or more kinds.

In the case of using the epoxy resin, it is preferable that the resin composition is a two-component curing type and a first component containing a base resin and a second component containing a curing agent are mixed to thereby be cured.

Then, in the case where the resin composition is a two-component curing type and constitutes either of a first component or a second component, it suffices when the resin composition contains either one of the epoxy compound constituting the base resin or the curing agent.

Even in the case of the two-component type, however, the epoxy resin, as far as curing does not proceed, may contain the curing agent or the epoxy compound in addition to the epoxy compound or the curing agent.

Then, in the case where the resin composition is a one-component curing type, and in the case where the resin composition, even when being a two-component curing type, is a mixture of its first component and its second component, it suffices when the resin composition contains both of the epoxy compound to become the base resin and the curing agent.

(Acrylic resin)

As the acrylic resin to be used as the resin component, for example, a photocurable one is used. The acrylic resin suffices as long as being a component which constitutes an acrylic polymer by being cured, and examples thereof include various acrylic compounds including (meth) acrylates such as alkyl (meth) acrylates and hydroxyalkyl (meth) acrylates, (meth) acrylic acid, (meth) acrylamides and urethane (meth) acrylate. Further, a vinyl monomer and the like copolymerizable with the above acrylic compounds may be contained.

The volume percentage of the matrix resin is, with respect to the total volume of the resin composition, preferably 3% by volume or higher and 20% by volume or lower, more preferably 5% by volume or higher and 18% by volume or lower and still more preferably 6% by volume or higher and 16% by volume or lower. When the volume percentage of the resin component is these lower limit values or higher, the fillers including the diamond to be dispersed in the matrix resin can suitably be dispersed and held in the matrix resin. By making the volume percentage to be these upper limit values or lower, the fillers including the diamond can be blended in a certain amount or more in the resin composition.

[Dispersant]

It is preferable that the resin composition of the present invention contains a dispersant. Containing a dispersant enhances the wettability of the diamond and makes it easy for the sliding effect of the diamond to be exhibited. Further, it becomes easy for the first filler and the second filler to be dispersed in the resin composition and for the fillers to be blended in a large amount in the resin composition.

The dispersant includes silicone compounds having a polar group on an end or side chain thereof. Here, examples of the polar group include an alkoxy group, a hydroxyl group, an acyloxy group, a carbonyl group, a carboxy group, an aldehyde group, an amino group and a cyano group; preferable are an alkoxy group and a hydroxyl group, and more preferable is an alkoxy group. The polar group is bound preferably to a Si atom; accordingly, the polar group is preferably a hydrolyzable silyl group such as a silanol group or an alkoxysilyl group, and is more preferably an alkoxysilyl group. Then, the silicone compound having a polar group on an end or side chain thereof is preferably a silicone compound having the polar group on an end thereof.

It is preferable that the silicone compound having a polar group on an end or side chain thereof is used in the case where the matrix resin is a silicone resin.

Due to that the resin composition contains the silicone compound having a polar group as the dispersant, the polar group of the dispersant is bound to or interacts with functional groups present in a minute amount on the surface of the diamond and other fillers to enhance the slidability of the fillers, and makes it easy for the fillers to be dispersed in the matrix resin. In particular, the alkoxy group is hydrolyzed and easily reacts with the diamond surface; then, the hydroxyl group interacts with the polar groups on the filler surface and enters into the filler interface, making it easy for the slidability to be enhanced. Then in order to promote the hydrolysis of the alkoxy group, the resin composition is allowed to be subjected to a vacuum heat treatment.

Further, due to using the silicone compound as the dispersant, in use of the silicone resin as the matrix resin, it becomes especially easy for the fillers to be compatible with the matrix resin, and it becomes easy for the volume percentage of the fillers in the resin composition to be increased.

The silicone compound having a polar group on an end or side chain thereof is preferably an organopolysiloxane having a hydrolyzable silyl group on a molecular chain end (hereinafter, referred to also as organopolysiloxane (X)). The organopolysiloxane (X) may be a straight-chain one or a branched-chain one, or may be a mixture of a straight-chain one and a branched-chain one, but is preferably a straight-chain type. The organopolysiloxane (X) is preferably an organopolysiloxane having at least one hydrolyzable silyl group on a molecular chain end thereof, more preferably an organopolysiloxane having at least one hydrolyzable silyl group only on one end thereof, and still more preferably an organopolysiloxane having three hydrolyzable silyl groups on one end thereof. Here, the hydrolyzable silyl group is more preferably an alkoxysilyl group and still more preferably a methoxysilyl group.

Due to that the organopolysiloxane (X) has a hydrolyzable silyl group on its end, it makes easy for the organopolysiloxane (X) to react with or interact with functional groups present on the filler surface, and it makes easy for the slidability of the fillers to be enhanced. Then, conjointly with having a polysiloxane structure, the dispersibility of the fillers becomes good.

The organopolysiloxane (X) is specifically preferably a compound represented by the following formula (1).

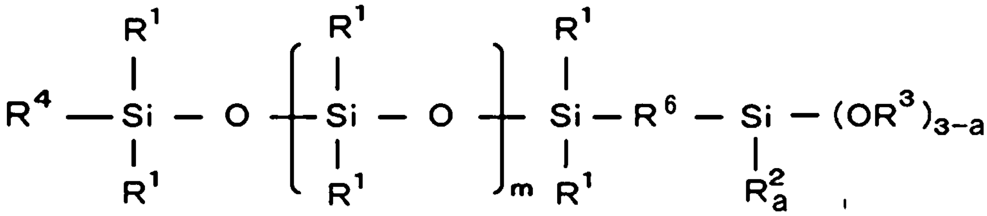

(1)

In the formula (1), $R^1$ are each independently an alkyl group having 1 to 20 carbon atoms, a halogenated alkyl group having 1 to 20 carbon atoms, an aryl group having 6 to 20 carbon atoms or an aralkyl group having 7 to 20 carbon atoms, and the plurality of $R^1$ may be identical or different from each other; $R^2$ are each independently an alkyl group having 1 to 4 carbon atoms, and in the case where $R^2$ is plural, the plurality of $R^2$ may be identical or different from each other; $R^3$ are each independently an alkyl group having 1 to 4 carbon atoms, an alkoxyalkyl group having 2 to 4 carbon atoms, a hydrogen atom or an acyl group having 2 to 4 carbon atoms, and in the case where $R^3$ is plural, the plurality of $R^3$ may be identical or different from each other; $R^4$ is an alkyl group having 1 to 8 carbon atoms; $R^6$ is an oxygen atom or a divalent organic group having 1 to 40 carbon atoms; the letter of m is an integer of 3 to 315; and the letter of a is an integer of 0 to 2.

In the above formula (1), the alkyl group in $R^1$ may be a straight-chain one or a branched-chain one, or may have a cyclic structure. The alkyl group more specifically includes straight-chain alkyl groups such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group and an eicosyl group, branched-chain alkyl groups such as an isopropyl group, a tertiary-butyl group, an isobutyl group, 2-methylundecyl group and 1-hexylheptyl group, and cyclic alkyl groups such as a cyclopentyl group, a cyclohexyl group and a cyclododecyl group.

The halogenated alkyl group includes a chloromethyl group, a 3,3,3-trifluoropropyl group, a 3-chloropropyl group and the like. The aryl group includes a phenyl group, a tolyl group, a xylyl group and the like. The aralkyl group includes a benzyl group, a phenethyl group, a 2-(2,4-6-trimethylphenyl)propyl group and the like.

Among these, $R^1$ is preferably an alkyl group having 1 to 20 carbon atoms, more preferably an alkyl group having 1 to 4 carbon atoms and still more preferably a methyl group. In the compound of the formula (1), preferably, 80% or more of $R^1$ is a methyl group; more preferably, 90% or more thereof; and still more preferably, 100% thereof.

In the above formula (1), $R^2$ is an alkyl group having 1 to 4 carbon atoms, and in the case where $R^2$ is plural (that is, in the case where a is 2), the plurality of $R^2$ may be identical or different from each other. Further, the alkyl group may be a straight-chain one or a branched-chain one. Among these, $R^2$ is preferably an alkyl group having 1 or 2 carbon atoms and more preferably a methyl group. Then, the letter of a is an integer of 0 to 2, and preferably 0 or 1 and more preferably 0.

In the above formula (1), $R^3$ is an alkyl group having 1 to 4 carbon atoms, an alkoxyalkyl group having 2 to 4 carbon atoms, a hydrogen atom or an acyl group having 2 to 4 carbon atoms. In the case where $R^3$ is plural (that is, in the case where the letter of a is 0 or 1), the plurality of $R^3$ may be identical or different from each other. The alkyl group, the alkoxyalkyl group and the acyl group in $R^3$ may be a straight-chain one or a branched-chain one. Among these, $R^3$ is preferably an alkyl group having 1 to 4 carbon atoms and more preferably a methyl group.

In the above formula (1), $R^4$ is an alkyl group having 1 to 8 carbon atoms and preferably an alkyl group having 2 to 6 carbon atoms and more preferably a butyl group.

In the above formula (1), $R^6$ is preferably a group represented by the following formula (2), an oxygen atom or a

divalent hydrocarbon group having 1 to 20 carbon atoms, and more preferably a group represented by the following formula (2) or a divalent hydrocarbon group having 1 to 20 carbon atoms. Here, the divalent hydrocarbon group having 1 to 20 carbon atoms is preferably an alkylene group, and the alkylene group may be a straight-chain one or a branched-chain one. The divalent hydrocarbon group having 1 to 20 carbon atoms is preferably an alkylene group having 2 to 10 carbon atoms, more preferably an alkylene group having 2 to 8 carbon atoms and still more preferably an alkylene group having 2 to 4 carbon atoms; and examples thereof include a methylene group, an ethylene group, a propylene group, a butylene group and a methylethylene group, and among these, an ethylene group is preferable.

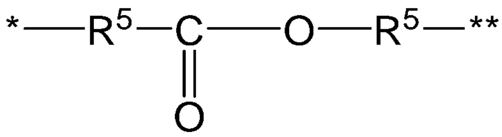

(2)

In the formula (2), $R^5$ is a divalent hydrocarbon group having 1 to 20 carbon atoms, and the plurality of $R^5$ are identical or different from each other. The mark of * is a binding position with a silicon atom in $R^1$-Si-$R^1$; and the mark of ** is a binding position with a silicon atom in $SiR^2_a(OR^3)_{3-a}$.

The divalent hydrocarbon group in $R^5$ is preferably an alkylene group, and the alkylene group may be a straight-chain one or a branched-chain one. $R^5$ is preferably an alkylene group having 2 to 10 carbon atoms, more preferably an alkylene group having 2 to 8 carbon atoms, still more preferably an alkylene group having 2 to 4 carbon atoms and further still more preferably an alkylene group represented by $-CH_2-CH_2-CH_2-$ or $-CH(CH_3)-CH_2-$.

The letter of m in the formula (1) denotes a repeating number and is an integer of 3 to 315, and preferably an integer of 4 to 280, more preferably an integer of 5 to 220 and still more preferably an integer of 5 to 100.

As the dispersant, a dispersant other than the silicone compound is also usable, and a polymeric dispersant other than the silicone compound is usable. The polymeric dispersant to be used includes polymeric compounds having a functional group. Examples of the polymeric compound include acrylic, vinyl-based, polyester-based, polyurethane-based, polyether-based, epoxy-based, polystyrene-based and amine-based ones. Then, the functional group includes polar groups such as a carboxyl group, a phosphoric acid group, a sulfonic acid group, a carboxylate ester group, a phosphate ester group, a sulfonate ester group, a hydroxyl group, an amino group, quaternary ammonium salt groups and an amido group, and a phosphate ester group is preferable.

It is preferable that the polymeric dispersant other than the silicone compound is used in the case where the matrix resin contains a resin other than the silicone resin, such as an epoxy resin or an acrylic resin.

The functional group of the above-mentioned polymeric dispersant is bound to or interacts with functional groups present in a minute amount on the surface of the diamond and other fillers to enhance the slidability of the fillers, and makes it easy for the fillers to be dispersed in the matrix resin. Then, due to that the dispersant is a polymeric compound other than the silicone compound, when a resin component (for example, an epoxy resin or an acrylic resin) other than the silicone resin is used as the matrix resin, it becomes easy for the fillers to be especially compatible with the matrix resin and it becomes easy for the volume percentage of the fillers in the resin composition to be increased.

As the dispersant, a dispersant other than the polymeric dispersant is also usable. For example, an alkoxysilane compound is also usable. The alkoxysilane compound is a compound in which 1 to 3 bonds among 4 bonds of a silicon atom (Si) are bound with alkoxy groups and the residual bonds are bound with organic substituents. The alkoxy group of the alkoxysilane compound is a hydrolyzable group, and examples thereof include a methoxy group, an ethoxy group, a propoxy group, a butoxy group, a pentoxy group and a hexatoxy group; among these, the alkoxysilane compound having a methoxy group or an ethoxy group is preferable.

The number of the alkoxy group of the alkoxysilane is, from the viewpoint of enhancing the affinity for the fillers such as the diamond or the like, preferably 3. Therefore, the alkoxysilane compound is more preferably at least one kind selected from trimethoxysilane compounds and triethoxysilane compounds.

Examples of a functional group contained in the organic substituent in the alkoxysilane compound include an acryloyl group, alkyl groups, a carboxyl group, a vinyl group, a methacrylic group, aromatic groups, an amino group, an isocyanate group, an isocyanurate group, an epoxy group, a hydroxyl group and a mercapto group.

The alkoxysilane compound is, from the viewpoint that it becomes easy for the alkoxysilane compound to become compatible with the silicone resin and the dispersibility of the fillers such as the diamond or the like to be enhanced, preferably an alkylalkoxysilane compound having an alkyl group bound to a silicon atom. The number of carbon atoms of the alkyl group bound to a silicon atom is, from the viewpoint that the viscosity of the alkoxysilane compound itself is relatively low and the viscosity of the resin composition is suppressed low, preferably 16 or smaller.

Preferable alkylalkoxysilane compounds include n-hexyltrimethoxysilane, n-hexyltriethoxysilane, n-octyltriethoxysilane and n-decyltrimethoxysilane.

The alkoxysilane compounds other than the alkylalkoxysilane compounds include 3-acryloxypropyltrimethoxysilane, 3-methacryloxypropyltrimethoxysilane, 3-isocyanatopropyltriethoxysilane, 3-(2-aminoethyl)aminopropyltrimethoxysilane, 3-mercaptopropyltrimethoxysilane, glycidoxypropyltrimethoxysilane, glycidoxypropyltriethoxysilane, 3-phenylaminopropyltrimethoxysilane and the like.

As the dispersant, the above-mentioned dispersants may be used singly in one kind, or may be used concurrently in two or more kinds.

The volume percentage of the dispersant in the resin composition is, with respect to the total volume of the resin composition, preferably 0.1% by volume or higher and 15% by volume or lower, more preferably 0.3% by volume or higher and 12% by volume or lower, still more preferably 0.5% by volume or higher and 10% by volume or lower and further still more preferably 1.0% by volume or higher and 9% by volume or lower. By making the content to be these lower limit values or higher, it becomes easy for the fillers such as the diamond or the like to be suitably dispersed and for the slidability to be suitably imparted to the fillers. Then, by making the content to be the upper limit values or lower, the dispersibility corresponding to the content can be imparted.

(Other additives)

The resin composition, in the case of a curing type, may suitably contain a curing catalyst. For example, in the case of using an addition reaction-curing type silicone resin, the curing catalyst includes platinum-based catalysts, palladium-based catalysts and rhodium-based catalysts. These curing catalysts are catalysts for curing the silicone resin to become the base resin and the silicone resin to become the curing agent. The amount of the curing catalyst to be blended is, in terms of mass with respect to the silicone resins, usually 0.1 to 200 ppm, and preferably 0.5 to 100 ppm. In the case of the two-component curing type, it is preferable that the curing catalyst is blended in the first component, but may be contained in the second component containing the curing agent.

The resin composition of the present invention, as required, may contain additives generally used for heat-dissipating members, such as an antioxidant, a thermal stabilizer, a colorant, a flame retardant and an antistatic agent. Then, in the case of using a curable resin such as a thermocurable resin, the resin composition may contain a curing retarder. In the case of the two-component curing type, it is preferable that the curing retarder is contained, for example, in the second component containing the curing agent, and it is more preferable that the curing retarder is contained in the second component containing the base resin in addition to the curing agent. By suppressing the catalytic activity of the curing catalyst and the activity of the curing agent by containing the curing retarder, the shelf life and the pot life of the resin composition can be prolonged. In the case of using a photocurable resin, the resin composition may contain a photopolymerization initiator.

(Physical properties of the resin composition)

By making the resin composition of the present invention to contain the specific first and second fillers and making the volume percentages of the fillers and the diamond to be in the above predetermined ranges, the thermal conductivity of the resin composition is made high. The thermal conductivity of the resin composition is, for example, 7.5 W/(m·K) or higher, but preferably 9.0 W/(m·K) or higher, more preferably 10 W/(m·K) or higher and still more preferably 11 W/(m·K) or higher. Then, a higher thermal conductivity of the resin composition gives a better heat dissipation property, but it is desirable that the thermal conductivity is, for example, 30 W/(m·K) or lower.

It is preferable that the viscosity at room temperature (25°C) of the resin composition of the present invention is a certain value or lower. Making the viscosity be a certain value or lower makes it easy for the coatability, the formability and the like to be made good. Specifically, the viscosity at 25°C of the resin composition suffices when being, for example, 1,000 Pa·s or lower, but is preferably 700 Pa·s or lower, more preferably 600 Pa·s or lower and still more preferably 450 Pa·s or lower.

The viscosity at 25°C of the resin composition is not especially limited, but is, in order to prevent liquid sagging and the like, preferably 5 Pa·s or higher, more preferably 20 Pa·s or higher and still more preferably 50 Pa·s or higher.

Here, in the present description, the viscosity of the resin composition is a viscosity at 25°C and measured according to JIS K6249, and indicates a viscosity measured by using a rotational viscometer rotator N0. 7 at a rotation speed of 10 rpm at the time of 3 min.

Then, the viscosity of the resin composition in the case of being curable is a viscosity of the resin composition before being cured. For example, in the case where the resin composition is a two-component curing type and a mixture of a first component and a second component, the viscosity is that right after the first component and the second component are mixed.

(Preparation of the resin composition)

The resin composition of the present invention can be prepared by mixing the matrix resin, the fillers, further, additives such as the dispersant to be blended according to needs, and the like. A method of mixing these components is

not especially limited, but the resin composition can be prepared, for example, by adding the fillers and the additives such as the dispersant to be blended according to needs, and the like to the matrix resin, and thereafter subjecting the resultant to stirring, kneading or the like.

The fillers may be surface treated with the dispersant, and then, mixed with the matrix resin. The in-advance surface treatment of the fillers with the dispersant results in in-advance surface modification with the dispersant. Then, the resin composition is prepared by mixing the fillers surface treated in advance in the matrix resin.

A process of the in-advance surface treatment with the dispersant is not especially limited, and a well-known process suffices; for example, a wet treatment process, a dry treatment process or the like can be used. The wet treatment process involves, for example, adding and mixing the fillers to and with a treatment liquid in which the dispersant is dispersed or dissolved in a solvent, and thereafter subjecting the resultant to drying, heat treatment, cleaning and the like to make the dispersant to be bound or adhered to or on the filler surface.

The dry process is a process of surface treatment using no solvent; specifically, the process is one in which the dispersant is mixed in the fillers and stirred by a mixer or the like, and thereafter, heat treated to make the dispersant to be bound or adhered to or on the diamond particle surface.

[Heat-dissipating member]

The heat-dissipating member of the present invention is one formed of the above-mentioned resin composition. For example, in the case where the resin component contains the curable resin, it is possible to obtain the heat-dissipating member formed into a predetermined shape by forming the resin composition into the predetermined shape and thereafter curing the resin composition with heating the resin composition appropriately or the like. Then, in the case of using the photocurable resin, it is possible to obtain the heat-dissipating member by forming the resin composition into the predetermined shape and thereafter subjecting the resin composition to irradiation with light such as ultraviolet light to cure the resin composition. Also in cases other than the case where the resin component contains the curable resin, it is possible to make the heat-dissipating member by forming the resin composition into a predetermined shape, or an indeterminate shape. A method of forming the resin composition into a predetermined shape is not especially limited, and the resin composition may be formed into a thin film shape, a sheet shape, a block shape or the like, or an indeterminate shape, by coating, casting, potting, extrusion or the like. Coating may be carried out, for example, by using a dispenser. Since the resin composition of the present invention is good in the flowability, coating, casting, potting, extrusion or the like can easily be carried out and the dischargeability from the dispenser becomes good.

In the case of the two-component curing type, the heat-dissipating member formed into a predetermined shape can be obtained by making a mixture of the first component and the second component into the predetermined shape and thereafter curing the resultant.

The heat-dissipating member of the present invention is used, for example, in electronic devices. That is, the present invention provides also an electronic device equipped with the heat-dissipating member. Since the heat-dissipating member of the present invention is high in the thermal conductivity, it can secure the high heat dissipation property when being used inside electronic devices. More specifically, the heat-dissipating member is disposed on an electronic component and used to dissipate heat generated by the electronic component. Then, it is preferable that the heat-dissipating member of the present invention is disposed and used so as to fill a gap between two opposing members. The two opposing members may be, for example, such a combination that one member is an electronic component and the other member is one of a heat sink to dissipate heat from the electronic component, a housing of electronic devices, a substrate and the like.

Examples

Hereinafter, Examples of the present invention will be described. However, the present invention is not any more limited to the following Examples.

Measurement methods and evaluation methods of physical properties of the present invention were as follows.

<Volume-average particle diameter>

The volume-average particle diameter for primary particle diameter of each filler, the first filler and the second filler each was determined by measuring a 50% particle diameter (D50) in a cumulative particle size distribution in terms of volume by the method described in the present description.

<Sphericity>

The sphericity was determined by examining an electron microscope photograph and, for each particle in the

obtained image, calculating (the diameter of a circle whose area is equivalent to a projected area of a particle/the diameter of the smallest circle circumscribing a projected image of the particle). In present Examples and Comparative Examples, for each filler, the sphericities of 300 particles were determined and the average thereof was taken as the sphericity of each filler, and is described in Tables 2 to 5.

<Viscosity>

The viscosity of the resin composition was measured by the method described in the present description. A rotational viscometer used was a "DV-E", manufactured by BROOKFIELD, and a rotator used was a Spindle No. 7.

<Volume percentage>

In Examples and Comparative Examples, the volume percentage of each component was calculated by the following method. The parts by volume of each component was calculated by dividing the number of parts (parts by mass) of each component of the matrix resin, the dispersant, the fillers and the like by the density thereof, and a value obtained by dividing the value of the calculated parts by volume of each component of the matrix resin, the dispersant, the fillers and the like by a value of the total parts by volume of all the materials was taken as the volume percentage (% by volume).

<Thermal conductivity>

Each resin composition obtained in Examples, Comparative Examples and Reference Examples was immediately coated on a measurement part of a measurement apparatus so as to make a thickness D of 700 μm; and the thermal resistance value of the resin composition at this time was measured by using an apparatus "DynTIM", manufactured by Mentor Graphics Corp. according to ASTM D5470. Thereafter, also in the case of the thickness of 500 μm and in the case of the thickness of 400 μm, the thermal resistance value was similarly measured. The thermal conductivity was calculated by the following expression from the obtained thermal resistance value for each thickness.

$$\text{Expression: Thermal conductivity } (\mathrm{W/(m\cdot K)}) = \Delta D \text{ (unit: mm)}/\ \Delta W \text{ (unit: } \mathrm{K\cdot cm^2/W})$$

<Flow rate value>

A 30mL syringe (tip end diameter: 2 mm) was filled with each resin composition obtained in Examples, Comparative Examples and Reference Examples and then was vacuum deaerated. Thereafter, a pressure of 0.42 MPa was applied on the syringe by using a digital dispenser, and an amount of the resin composition discharged for 10 sec was measured; and an amount (g) thereof discharged per 1 min was calculated and taken as the flow rate value (g/min). The digital dispenser used was an "ML-5000XII", manufactured by Musashi Engineering, Inc.

<Evaluation score>

The thermal conductivity and the flow rate value measured in each of Examples and Comparative Examples were scored according to the following Table 1, and the performance was evaluated by using the total point. A high point indicated being higher in the performance and 11 or more points were taken as acceptable.

[Table 1]

| | Points | W/ (m·K) | | Points | g/min |
|---|---|---|---|---|---|
| Thermal conductivity | 0 | less than 7.5 | flow rate | 0 | less than 5 |
| | 1 | 7.5 or more and less than 8 | | 1 | 5 or more and less than 10 |
| | 2 | 8 or more and less than 8.5 | | 2 | 10 or more and less than 20 |
| | 3 | 8.5 or more and less than 9 | | 3 | 20 or more and less than 30 |
| | 4 | 9 or more and less than 9.5 | | 4 | 30 or more and less than 40 |
| | 5 | 9.5 or more and less than 10 | | 5 | 40 or more and less than 50 |
| | 6 | 10 or more and less than 10.5 | | 6 | 50 or more and less than 60 |
| | 7 | 10.5 or more and less than 11 | | 7 | 60 or more and less than 70 |
| | 8 | 11 or more and less than 11.5 | | 8 | 70 or more and less than 80 |
| | 9 | 11.5 or more and less than 12 | | 9 | 80 or more and less than 90 |
| | 10 | 12 or more | | 10 | 90 or more |

Each component used in Examples and Comparative Examples was as follows.

<Matrix resins>

Silicone resins

Silicone resin 1: 100 mPa·s, a vinyl group-containing organopolysiloxane, containing a platinum catalyst in a catalytic amount
Silicone resin 2: 100 mPa·s, a mixture of a vinyl group-containing organopolysiloxane and an SiH-containing organopolysiloxane, containing a curing retarder in a small amount
Silicone resin 3: 110 mPa·s, a dimethylpolysiloxane (silicone oil, trade name: "SH200CV", manufactured by Mitsubishi Chemical Corp.)
Epoxy resin: 70 mPa·s, epoxy equivalent 268 (g/eq.), ethylene glycol diglycidyl ether (trade name: "Deconal EX-830", manufactured by Nagase Chemtex Corp.)
Epoxy resin curing agent: 165 mPa·s, amine value 630 (KOHmg/g), a modified aliphatic amine (trade name: "WA", manufactured by Mitsubishi Chemical Corp.)
Acrylic resin: a mixture of an acrylic resin (1) (trade name: "4-hydroxybutyl acrylate", manufactured by Osaka Organic Chemical Industry Ltd.) and an acrylic resin (2) (trade name: "CN9005", manufactured by Arkema Co. Ltd.) (mass ratio: acrylic resin (1) : acrylic resin (2) = 20 : 1)

<Dispersants>

Dispersant 1: an organopolysiloxane in which in the chemical formula (1), $R^1$ and $R^3$ are a methyl group; the letter of a is 0; $R^4$ is a butyl group; $R^6$ has a structure of the chemical formula (2); among $R^5$, $R^5$ bound directly to a carbonyl group is an isopropylene group (having a methyl group on the carbonyl $\alpha$ position and bound to a siloxane silicon atom on the carbonyl $\beta$ position in the chemical formula (1)), and the other $R^5$ is a propylene group.
Dispersant 2: 3-glycidoxypropyltriethoxysilane, item number: "KBE-403", manufactured by Shin-Etsu Chemical Co. Ltd.
Dispersant 3: acryloxypropyltrimethoxysilane, item number: "KBM-5103", manufactured by Shin-Etsu Chemical Co. Ltd.

<Fillers>

The density, the sphericity and the volume-average particle diameter for primary particle diameter of each filler were as indicated in Tables 2 to 5.

(Zinc oxide)

Zinc oxide 1: a zinc oxide having an average particle diameter of 0.42 μm, manufactured by Hakusui Tech Co. Ltd., sphericity: 0.6

(Aluminas)

Alumina 1: an alumina having an average particle diameter of 0.32 μm, manufactured by Sumitomo Chemical Co. Ltd., sphericity: 0.8
Alumina 2: an alumina having an average particle diameter of 0.58 μm, manufactured by Sumitomo Chemical Co. Ltd., sphericity: 0.8
Alumina 3: an alumina having an average particle diameter of 1.7 μm, manufactured by Sumitomo Chemical Co. Ltd., sphericity: 0.8
Alumina 4: an alumina having an average particle diameter of 6.6 μm, manufactured by Sumitomo Chemical Co. Ltd., sphericity: 0.8
Alumina 5: an alumina having an average particle diameter of 20.3 μm, manufactured by Sumitomo Chemical Co. Ltd., sphericity: 0.8

(Polyhedral alumina)

Polyhedral alumina 1: a polyhedral alumina having an average particle diameter of 32 μm, manufactured by DIC Corp., sphericity: 0.8

(Aluminum nitrides)

Aluminum nitride 1: an aluminum nitride having an average particle diameter of 1.0 μm, manufactured by Tokuyama Corp., sphericity: 0.7
Aluminum nitride 2: an aluminum nitride having an average particle diameter of 4.7 μm, manufactured by Tokuyama Corp., sphericity: 0.7
Aluminum nitride 3: an aluminum nitride having an average particle diameter of 18.3 μm, manufactured by Tokuyama Corp., sphericity: 0.7
Aluminum nitride 4: an aluminum nitride having an average particle diameter of 37.0 μm, manufactured by Tokuyama Corp., sphericity: 0.95
Aluminum nitride 5: an aluminum nitride having an average particle diameter of 78.0 μm, manufactured by Tokuyama Corp., sphericity: 0.95
Aluminum nitride 6: an aluminum nitride having an average particle diameter of 98.0 μm, manufactured by Combustion Synthesis Co., Ltd., sphericity: 0.7

(Crushed diamond)

Crushed diamond 1: a crushed diamond having an average particle diameter of 69.5 μm, manufactured by Hyperion Technologies Inc., sphericity: 0.6

(As-Grown diamonds)

As-Grown diamond 1: an hexoctahedral As-Grown diamond having an average particle diameter of 9.9 μm, manufactured by Tomei Diamond Industrial Co. Ltd., sphericity: 0.9
As-Grown diamond 2: an hexoctahedral As-Grown diamond having an average particle diameter of 18.6 μm, manufactured by Tomei Diamond Industrial Co. Ltd., sphericity: 0.9
As-Grown diamond 3: an hexoctahedral As-Grown diamond having an average particle diameter of 23.0 μm, manufactured by Tomei Diamond Industrial Co. Ltd., sphericity: 0.9
As-Grown diamond 4: an hexoctahedral As-Grown diamond having an average particle diameter of 34.0 μm,

manufactured by Tomei Diamond Industrial Co. Ltd., sphericity: 0.9
As-Grown diamond 5: an hexoctahedral As-Grown diamond having an average particle diameter of 48.9 μm, manufactured by Tomei Diamond Industrial Co. Ltd., sphericity: 0.9
As-Grown diamond 6: an hexoctahedral As-Grown diamond having an average particle diameter of 68.3 μm, manufactured by Tomei Diamond Industrial Co. Ltd., sphericity: 0.9
As-Grown diamond 7: an hexoctahedral As-Grown diamond having an average particle diameter of 118.5 μm, manufactured by Tomei Diamond Industrial Co. Ltd., sphericity: 0.9

[Example 1]

In the silicone resin 1, as a matrix resin, containing a vinyl group-containing organopolysiloxane and platinum in a catalytic amount, fillers and a dispersant were mixed in a formulation indicated in Table 2 to thereby prepare a first component of a resin composition.

Then, in the silicone resin 2 containing a mixture of a vinyl group-containing organopolysiloxane and an SiH-containing organopolysiloxane, and a curing retarder in a small amount, fillers and a dispersant were mixed in a formulation indicated in Table 2 to thereby prepare a second component of the resin composition.

The first component and the second component were mixed in a mass ratio (first component/second component) of 1 : 1 to thereby prepare the resin composition, which was then evaluated.

[Examples 2 to 15, Examples 18 to 20, Comparative Examples 2 to 11]

The same procedure was carried out as in Example 1, except for changing the kinds of fillers used and the amount of each component blended as indicated in Tables 2 to 5.

[Example 16]

In the epoxy resin (trade name: "Deconal EX-830", manufactured by Nagase Chemtex Corp.), as a matrix resin, fillers and a dispersant were mixed in a formulation indicated in Table 3 to thereby prepare a first component of a resin composition.

Then, in the epoxy resin curing agent (trade name: "WA", manufactured by Mitsubishi Chemical Corp.), fillers and a dispersant were mixed in a formulation indicated in Table 3 to thereby prepare a second component of the resin composition.

The first component and the second component were mixed in a mass ratio (first component : second component) of 1 : 2.65 to thereby prepare the resin composition, which was then evaluated.

[Example 17]

To a mixture obtained by adding 0.01 parts by mass of a photopolymerization initiator (trade name: "OMNIRAD 819", manufactured by IGM Resins B.V.) to the mixture, as a matrix resin, of an acrylic resin (1) (trade name: "4-hydroxybutyl acrylate", manufactured by Osaka Organic Chemical Industry Ltd.) and an acrylic resin (2) (trade name: "CN9005", manufactured by Arkema Co. Ltd.) (mass ratio: acrylic resin (1) : acrylic resin (2) = 20 : 1), fillers and a dispersant were added in the numbers of parts blended indicated in Table 4 to thereby prepare a resin composition, which was then evaluated.

[Example 21]

To the dimethylpolysiloxane (silicone oil, trade name: "SH200CV", manufactured by Mitsubishi Chemical Corp.), as a matrix resin, fillers and a dispersant were added in the numbers of parts blended indicated in Table 4 to thereby prepare a resin composition, which was then evaluated.

[Comparative Example 1]

The same procedure was carried out as in Example 16, except for changing the kinds of fillers used and the amount of each component blended as indicated in Table 4.

[Table 2]

| | | | Density (g/cc) | Sphericity | Volume-average particle diameter (μm) | Example 1 | | Example 2 | | Example 3 | | Example 4 | | Example 5 | | Example 6 | | Example 7 | | Example 8 | |
|---|---|---|---|---|---|---|---|---|---|---|---|---|---|---|---|---|---|---|---|---|---|
| | | | | | | first component | second component | first component | second component | first component | second component | first component | second component | first component | second component | first component | second component | first component | second component | first component | second component |
| Kind of first filler | | | | | | AG diamond | AG diamond | AG diamond | AG diamond | AG diamond | AG diamond | AG diamond | AG diamond | AG diamond | AG diamond | AG diamond | AG diamond | AG diamond | AG diamond | AG diamond | AG diamond |
| Kind of second filler | | | | | | alumina | alumina | alumina | alumina | alumina | alumina | alumina | alumina | alumina | alumina | alumina | alumina | alumina | alumina | alumina | alumina |
| Volume percentage (% by volume) | Whole of fillers | | | | | 85 | 85 | 85 | 85 | 85 | 85 | 85 | 85 | 85 | 85 | 85 | 85 | 85 | 85 | 85 | 85 |
| | First filler | | | | | 20.1 | 20.1 | 26.3 | 26.3 | 40.4 | 40.4 | 50.2 | 50.2 | 57.8 | 57.8 | 67.3 | 67.3 | 69.9 | 69.9 | 57.7 | 57.7 |
| | Diamond | | | | | 20.1 | 201 | 26.3 | 26.3 | 40.4 | 40.4 | 50.2 | 50.2 | 57.8 | 57.8 | 67.3 | 67.3 | 69.9 | 69.9 | 57.7 | 57.7 |
| | Second filler | | | | | 64.9 | 64.9 | 58.7 | 58.7 | 44.6 | 44.6 | 34.8 | 34.8 | 27.2 | 27.2 | 17.7 | 17.7 | 15.1 | 15.1 | 27.3 | 27.3 |
| | Aluminum nitride | | | | | - | - | - | - | - | - | - | - | - | - | - | - | - | - | - | - |
| | Matrix resin | | | | | 9 | 9 | 9 | 9 | 9 | 9 | 9 | 9 | 9 | 9 | 9 | 9 | 9 | 9 | 9 | 9 |
| | Dispersant | | | | | 6 | 6 | 6 | 6 | 6 | 6 | 6 | 6 | 6 | 6 | 6 | 6 | 6 | 6 | 6 | 6 |
| Formulation (parts by mass) | | Matrix resin | 0.97 | | | 1.704 | 1.704 | 1.884 | 1.884 | 2.331 | 2.331 | 2.226 | 2.226 | 2.61 | 2.61 | 2.616 | 2.616 | 3.084 | 3.084 | 2.19 | 2.19 |
| | | Kind of resin | | | | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 |
| | | Dispersant | 0.97 | | | 1.136 | 1.136 | 1.256 | 1.256 | 1.554 | 1.554 | 1.484 | 1.484 | 1.74 | 1.74 | 1.744 | 1.744 | 2.056 | 2.056 | 1.46 | 1.46 |
| | | Kind of dispersant | | | | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 |
| | Zinc oxide | zinc oxide 1 | 5.78 | 0.6 | 0.42 | | | | | | | | | | | | | | | | |
| | Alumina | alumina 1 | 3.94 | 0.8 | 0.32 | 7 | 7 | 7 | 7 | 7 | 7 | 7 | 7 | 11 | 11 | 11 | 11 | 11 | 11 | 7 | 7 |
| | | alumina 2 | 3.94 | 0.8 | 0.58 | 5 | 5 | 5 | 5 | 5 | 5 | 5 | 5 | | | | | | | 5 | 5 |
| | | alumina 3 | 3.94 | 0.8 | 1.7 | | | | | | | | | 10 | 10 | 10 | 10 | 10 | 10 | | |
| | | alumina 4 | 3.94 | 0.8 | 6.6 | 16 | 16 | 16 | 16 | 13 | 13 | 15 | 15 | | | | | | | 15 | 15 |
| | | alumina 5 | 3.94 | 0.8 | 20.3 | 22 | 22 | 22 | 22 | 22 | 22 | 8 | 8 | 11 | 11 | | | | | | |
| | Polyhedral alumina | polyhedral alumina 1 | 3.94 | 0.8 | 32.0 | | | | | | | | | | | | | | | | |
| | Aluminum nitride | aluminum nitride 1 | 3.26 | 0.7 | 1.0 | | | | | | | | | | | | | | | | |
| | | aluminum nitride 2 | 3.26 | 0.7 | 4.7 | | | | | | | | | | | | | | | | |
| | | aluminum nitride 3 | 3.26 | 0.7 | 18.3 | | | | | | | | | | | | | | | | |
| | | aluminum nitride 4 | 3.26 | 0.95 | 37.0 | | | | | | | | | | | | | | | | |
| | | aluminum nitride 5 | 3.26 | 0.95 | 78.0 | | | | | | | | | | | | | | | | |
| | | aluminum nitride 6 | 3.26 | 0.7 | 98.0 | | | | | | | | | | | | | | | | |
| | Crushed diamond | crushed diamond 1 | 3.52 | 0.6 | 69.5 | | | | | | | | | | | | | | | | |
| | AG diamond | As-Grown diamond 1 | 3.52 | 0.9 | 9.9 | | | | | | | | | | | 10 | 10 | 11 | 11 | | |
| | | As-Grown diamond 2 | 3.52 | 0.9 | 18.6 | | | | | | | | | 10 | 10 | 10 | 10 | 11 | 11 | | |
| | | As-Grown diamond 3 | 3.52 | 0.9 | 23.0 | | | | | | | | | | | | | | | | |
| | | As-Grown diamond 4 | 3.52 | 0.9 | 34.0 | | | | | | | 10 | 10 | | | | | | | 18 | 18 |
| | | As-Grown diamond 5 | 3.52 | 0.9 | 48.9 | | | | | | | - | - | 11 | 11 | 11 | 11 | 15 | 15 | | |
| | | As-Grown diamond 6 | 3.52 | 0.9 | 68.3 | 13.8 | 13.8 | 20 | 20 | 38 | 38 | 35 | 35 | 40 | 40 | 40 | 40 | 48 | 48 | | |
| | | As-Grown diamond 7 | 3.52 | 0.9 | 118.5 | | | | | | | | | | | | | | | 35 | 35 |
| Volume-average particle diameter for primary particle | | Volume-average particle diameter of first filler (μm) | | | | 68.3 | | 68.3 | | 68.3 | | 65.2 | | 62.5 | | 60.3 | | 61.2 | | 93.9 | |
| | | Volume-average particle diameter of second filler (μm) | | | | 18.8 | | 18.8 | | 18.5 | | 12.9 | | 13.2 | | 1.1 | | 1.1 | | 6.4 | |
| | | Ratio of volume-average particle diameters (second filler/first filler) | | | | 0.275 | | 0.275 | | 0.271 | | 0.198 | | 0.211 | | 0.018 | | 0.018 | | 0.068 | |
| Volume percentage of filler having a sphericity of 0.7 or higher in second filler | | | | | | 1 | | 1 | | 1 | | 1 | | 1 | | 1 | | 1 | | 1 | |
| Evaluation of resin composition | | Viscosity (Pa·s) | | | | 524 | | 560 | | 473 | | 440 | | 520 | | 570 | | 590 | | 489 | |
| | | Thermal conductivity (W/(m·K)) | | | | 10.1 | | 10.3 | | 11.1 | | 11.3 | | 12.1 | | 13.6 | | 13.4 | | 15.2 | |
| | | Flow rate (g/min) | | | | 49.5 | | 44.5 | | 42.8 | | 39.6 | | 21.9 | | 26.8 | | 20.5 | | 39.9 | |
| Evaluation score | | Thermal conductivity (score points) | | | | 6 | | 6 | | 8 | | 8 | | 10 | | 10 | | 10 | | 10 | |
| | | Flow rate (score points) | | | | 5 | | 5 | | 5 | | 4 | | 3 | | 3 | | 3 | | 4 | |
| | | Thermal conductivity + Flow rate (score points) | | | | 11 | | 11 | | 13 | | 12 | | 13 | | 13 | | 13 | | 14 | |

[Table 3]

| | | | Density (g/cc) | Sphericity | Volume-average particle diameter (μm) | Example 9 | | Example 10 | | Example 11 | | Example 12 | | Example 13 | | Example 14 | | Example 15 | | Example 16 | |
|---|---|---|---|---|---|---|---|---|---|---|---|---|---|---|---|---|---|---|---|---|---|
| | | | | | | first component | second component | first component | second component | first component | second component | first component | second component | first component | second component | first component | second component | first component | second component | first component | second component |
| Kind of first filler | | | | | | AG diamond | AG diamond | AG diamond | AG diamond | AG diamond | AG diamond | AG diamond | AG diamond | AG diamond | AG diamond | AG diamond | AG diamond | AG diamond | AG diamond | AG diamond | AG diamond |
| Kind of second filler | | | | | | alumina | alumina | alumina | alumina | alumina | alumina | alumina | alumina | alumina | alumina | alumina | alumina | alumina | alumina | alumina | alumina |
| Volume percentage (% by volume) | Whole of fillers | | | | | 87.5 | 87.5 | 85 | 85 | 85 | 85 | 85 | 85 | 85 | 85 | 87.5 | 87.5 | 87.5 | 87.5 | 85 | 85 |
| | First filler | | | | | 59.4 | 59.4 | 40.4 | 40.4 | 40.3 | 40.3 | 39.7 | 39.7 | 35.9 | 35.9 | 55.8 | 55.8 | 55.8 | 55.8 | 57.7 | 57.7 |
| | Diamond | | | | | 59.4 | 59.4 | 40.4 | 40.4 | 40.3 | 40.3 | 39.7 | 39.7 | 35.9 | 35.9 | 55.8 | 55.8 | 55.8 | 55.8 | 57.7 | 57.7 |
| | Second filler | | | | | 28.1 | 28.1 | 44.6 | 44.6 | 44.7 | 44.7 | 45.3 | 45.3 | 49.1 | 49.1 | 31.7 | 31.7 | 31.7 | 31.7 | 27.3 | 27.3 |
| | Aluminum nitride | | | | | - | - | 9.4 | 9.4 | 19.4 | 19.4 | 34.5 | 34.5 | 43 | 43 | 24.7 | 24.7 | 24.7 | 24.7 | - | - |
| | Matrix resin | | | | | 7.5 | 7.5 | 9 | 9 | 9 | 9 | 9 | 9 | 9 | 9 | 7.5 | 7.5 | 7.5 | 7.5 | 9 | 9 |
| | Dispersant | | | | | 5 | 5 | 6 | 6 | 6 | 6 | 6 | 6 | 6 | 6 | 5 | 5 | 5 | 5 | 6 | 6 |
| Formulation (parts by mass) | | Matrix resin | 0.97 | | | 1.773 | 1.773 | 2.268 | 2.268 | 2.274 | 2.274 | 2.13 | 2.13 | 2.55 | 2.55 | 1.812 | 1.812 | 1.812 | 1.812 | 2.19 | 2.19 |
| | | Kind of resin | | | | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | epoxy resin | epoxy resin curing agent |
| | | Dispersant | 0.97 | | | 1.182 | 1.182 | 1.512 | 1.512 | 1.516 | 1.516 | 1.42 | 1.42 | 1.7 | 1.7 | 1.208 | 1.208 | 1.208 | 1.208 | 1.46 | 1.46 |
| | | Kind of dispersant | | | | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 2 | dispersant 2 |
| | Zinc oxide | zinc oxide 1 | 5.78 | 0.6 | 0.42 | | | | | | | | | | | | | 10.3 | 10.3 | | |
| | Alumina | alumina 1 | 3.94 | 0.8 | 0.32 | 7 | 7 | 7 | 7 | 7 | 7 | 7 | 7 | 7 | 7 | 7 | 7 | | | 7 | 7 |
| | | alumina 2 | 3.94 | 0.8 | 0.58 | 5 | 5 | 4 | 4 | 4 | 4 | 4 | 4 | | | | | | | 5 | 5 |
| | | alumina 3 | 3.94 | 0.8 | 1.7 | | | | | | | | | | | | | | | | |
| | | alumina 4 | 3.94 | 0.8 | 6.6 | 15 | 15 | 15 | 15 | 15 | 15 | | | | | | | | | 15 | 15 |
| | | alumina 5 | 3.94 | 0.8 | 20.3 | | | 10 | 10 | | | | | | | | | | | | |
| | Polyhedral alumina | polyhedral alumina 1 | 3.94 | 0.8 | 32.0 | | | | | | | | | | | | | | | | |
| | Aluminum nitride | aluminum nitride 1 | 3.26 | 0.7 | 1.0 | | | | | | | | | 4 | 4 | 5 | 5 | 5 | 5 | | |
| | | aluminum nitride 2 | 3.26 | 0.7 | 4.7 | | | | | | | 10 | 10 | 10 | 10 | 15 | 15 | 15 | 15 | | |
| | | aluminum nitride 3 | 3.26 | 0.7 | 18.3 | | | 8 | 8 | 16.5 | 16.5 | 20 | 20 | 15 | 15 | | | | | | |
| | | aluminum nitride 4 | 3.26 | 0.95 | 37.0 | | | | | | | | | 12 | 12 | | | | | | |
| | | aluminum nitride 5 | 3.26 | 0.95 | 78.0 | | | | | | | | | | | | | | | | |
| | | aluminum nitride 6 | 3.26 | 0.7 | 98.0 | | | | | | | | | | | | | | | | |
| | Crushed diamond | crushed diamond 1 | 3.52 | 0.6 | 69.5 | | | | | | | | | | | | | | | | |
| | AG diamond | As-Grown diamond 1 | 3.52 | 0.9 | 9.9 | | | | | | | | | | | | | | | | |
| | | As-Grown diamond 2 | 3.52 | 0.9 | 18.6 | | | | | | | | | | | | | | | | |
| | | As-Grown diamond 3 | 3.52 | 0.9 | 23.0 | | | | | | | | | | | | | | | | |
| | | As-Grown diamond 4 | 3.52 | 0.9 | 34.0 | 16 | 16 | | | | | | | | | 14 | 14 | 14 | 14 | 18 | 18 |
| | | As-Grown diamond 5 | 3.52 | 0.9 | 48.9 | | | | | | | | | | | | | | | | |
| | | As-Grown diamond 6 | 3.52 | 0.9 | 68.3 | | | 37 | 37 | 37 | 37 | 37 | 37 | 37 | 37 | | | | | | |
| | | As-Grown diamond 7 | 3.52 | 0.9 | 118.5 | 35 | 35 | | | | | | | | | 35 | 35 | 35 | 35 | 35 | 35 |
| Volume-average particle diameter for primary particle | | Volume-average particle diameter of first filler (μm) | | | | 92.8 | | 68.3 | | 68.3 | | 68.3 | | 68.3 | | 92.8 | | 92.8 | | 93.9 | |
| | | Volume-average particle diameter of second filler (μm) | | | | 6.4 | | 8.6 | | 8.9 | | 12 | | 18.8 | | 5.4 | | 5.4 | | 6.4 | |
| | | Ratio of volume-average particle diameters (second filler/first filler) | | | | 0.069 | | 0.126 | | 0.130 | | 0.176 | | 0.275 | | 0.058 | | 0.058 | | 0.068 | |
| Volume percentage of filler having a sphericity of 0.7 or higher in second filler | | | | | | 1 | | 1 | | 1 | | 1 | | 1 | | 1 | | 0.34 | | 1 | |
| Evaluation of resin composition | | Viscosity (Pa·s) | | | | 653 | | 512 | | 521 | | 556 | | 570 | | 542 | | 589 | | 576 | |
| | | Thermal conductivity (W/(m·K)) | | | | 18.4 | | 11.5 | | 12.6 | | 14.2 | | 13.3 | | 17.1 | | 19 | | 16 | |
| | | Flow rate (g/min) | | | | 31 | | 45.8 | | 38 | | 30.4 | | 13.6 | | 30.1 | | 30.5 | | 29 | |
| Evaluation score | | Thermal conductivity (score points) | | | | 10 | | 9 | | 10 | | 10 | | 10 | | 10 | | 10 | | 10 | |
| | | Flow rate (score points) | | | | 4 | | 5 | | 4 | | 4 | | 2 | | 4 | | 4 | | 3 | |
| | | Thermal conductivity + Flow rate (score points) | | | | 13 | | 14 | | 14 | | 14 | | 12 | | 14 | | 14 | | 13 | |

[Table 4]

| | | | Density (g/cc) | Sphericity | Volume-average particle diameter (μm) | Example 17 | Example 18 | | Example 19 | | Example 20 | | Example 21 | Comparative Example 1 | | Comparative Example 2 | | Comparative Example 3 | |
|---|---|---|---|---|---|---|---|---|---|---|---|---|---|---|---|---|---|---|---|
| | | | | | | first component | first component | second component | first component | second component | first component | second component | first component | first component | second component | first component | second component | first component | second component |
| Kind of first filler | | | | | | AG diamond | AG diamond | AG diamond | AG diamond | AG diamond | AG diamond | AG diamond | AG diamond | AG diamond | AG diamond | AG diamond | AG diamond | AG diamond | AG diamond |
| Kind of second filler | | | | | | alumina | alumina | alumina | alumina | alumina | aluminum nitride/alumina | aluminum nitride/alumina | alumina | alumina | alumina | alumina | alumina | alumina | alumina |
| Volume percentage (% by volume) | Whole of fillers | | | | | 85 | 83 | 83 | 80 | 80 | 85 | 85 | 87.5 | 85 | 85 | 78 | 78 | 76 | 76 |
| | First filler | | | | | 57 7 | 49 | 49 | 47.2 | 47.2 | 55.4 | 55.4 | 55.8 | - | - | 46 | 46 | 44.9 | 44.9 |
| | Diamond | | | | | 57.7 | 49 | 49 | 47.2 | 47.2 | 55.4 | 55.4 | 55.8 | - | - | 46 | 46 | 44.9 | 44.9 |
| | Second filler | | | | | 27.3 | 34 | 34 | 32.8 | 32.8 | 29.6 | 29.6 | 31.7 | 85 | 85 | 32 | 32 | 31.1 | 31.1 |
| | Aluminum nitride | | | | | - | - | - | - | - | 22.9 | 22.9 | 24.7 | 59.5 | 59.5 | - | - | - | - |
| | Matrix resin | | | | | 9 | 10.2 | 10.2 | 12 | 12 | 9 | 9 | 7.5 | 9 | 9 | 13.2 | 13.2 | 14.4 | 14.4 |
| | Dispersant | | | | | 6 | 6.8 | 6.8 | 8 | 8 | 6 | 6 | 5 | 6 | 6 | 8.8 | 8.8 | 9.6 | 9.6 |
| Formulation (parts by mass) | | Matrix resin | 0.97 | | | 2.19 | 2.58 | 2.58 | 3.15 | 3.15 | 2.328 | 2.328 | 1.812 | 2.34 | 2.34 | 3.552 | 3.552 | 3.978 | 3.978 |
| | | Kind of resin | | | | acrylic resin | silicone resin 1 | silicone resin 2 | silicone resin 1 | silicone resin 2 | silicone resin 1 | silicone resin 2 | silicone resin 3 | epoxy resin | epoxy resin curing agent | silicone resin 1 | silicone resin 2 | silicone resin 1 | silicone resin 2 |
| | | Dispersant | 0.97 | | | 1.46 | 1.72 | 1.72 | 2.1 | 2.1 | 1.552 | 1.552 | 1.208 | 1.56 | 1.56 | 2.368 | 2.368 | 2.652 | 2.652 |
| | | Kind of dispersant | | | | dispersant 3 | dispersant 1 | dispersant 1 | dispersant 1 | dispersant 1 | dispersant 1 | dispersant 1 | dispersant 1 | dispersant 2 | dispersant 2 | dispersant 1 | dispersant 1 | dispersant 1 | dispersant 1 |
| | Zinc oxide | zinc oxide 1 | 5.78 | 0.6 | 0.42 | | | | | | | | | | | | | | |
| | Alumina | alumina 1 | 3.94 | 0.8 | 0.32 | 7 | 7 | 7 | 7 | 7 | 7 | 7 | 7 | 7 | 7 | 7 | 7 | 7 | 7 |
| | | alumina 2 | 3.94 | 0.8 | 0.58 | 5 | 5 | 5 | 5 | 5 | | | | 5 | 5 | 5 | 5 | 5 | 5 |
| | | alumina 3 | 3.94 | 0.8 | 1.7 | | | | | | | | | | | | | | |
| | | alumina 4 | 3.94 | 0.8 | 6.6 | 15 | 15 | 15 | 15 | 15 | | | | 15 | 15 | 15 | 15 | 15 | 15 |
| | | alumina 5 | 3.94 | 0.8 | 20.3 | | 8 | 8 | 8 | 8 | | | | | | 8 | 8 | 8 | 8 |
| | Polyhedral alumina | polyhedral alumina 1 | 3.94 | 0.8 | 32.0 | | | | | | | | | | | | | | |
| | Aluminum nitride | aluminum nitride 1 | 3.26 | 0.7 | 1.0 | | | | | | 5 | 5 | 5 | | | | | | |
| | | aluminum nitride 2 | 3.26 | 0.7 | 4.7 | | | | | | | | 15 | | | | | | |
| | | aluminum nitride 3 | 3.26 | 0.7 | 18.3 | | | | | | 15 | 15 | | | | | | | |
| | | aluminum nitride 4 | 3.26 | 0.95 | 37.0 | | | | | | | | | 17 | 17 | | | | |
| | | aluminum nitride 5 | 3.26 | 0.95 | 78.0 | | | | | | | | | 35 | 35 | | | | |
| | | aluminum nitride 6 | 3.26 | 0.7 | 98.0 | | | | | | | | | | | | | | |
| | Crushed diamond | crushed diamond 1 | 3.52 | 0.6 | 69.5 | | | | | | | | | | | | | | |
| | AG diamond | As-Grown diamond 1 | 3.52 | 0.9 | 9.9 | | | | | | | | | | | | | | |
| | | As-Grown diamond 2 | 3.52 | 0.9 | 18.6 | | | | | | | | | | | | | | |
| | | As-Grown diamond 3 | 3.52 | 0.9 | 23.0 | | | | | | | | | | | | | | |
| | | As-Grown diamond 4 | 3.52 | 0.9 | 34.0 | 18 | 10 | 10 | 10 | 10 | 12 | 12 | 14 | | | 10 | 10 | 10 | 10 |
| | | As-Grown diamond 5 | 3.52 | 0.9 | 48.9 | | | | | | | | | | | | | | |
| | | As-Grown diamond 6 | 3.52 | 0.9 | 68.3 | | 35 | 35 | 35 | 35 | 40 | 40 | | | | 35 | 35 | 35 | 35 |
| | | As-Grown diamond 7 | 3.52 | 0.9 | 118.5 | 35 | | | | | | | 35 | | | | | | |
| Volume-average particle diameter for primary particle | Volume-average particle diameter of first filler (μm) | | | | | 93.9 | 68.3 | | 68.3 | | 66.7 | | 92.8 | 65.2 | | | | | |
| | Volume-average particle diameter of second filler (μm) | | | | | 6.4 | 18.5 | | 18.5 | | 13.4 | | 5.4 | 6.4 | | 18.5 | | 18.5 | |
| | Ratio of volume-average particle diameters (second filler/first filler) | | | | | 0.068 | 0.271 | | 0.271 | | 0.201 | | 0.058 | 0.098 | | - | | - | |
| Volume percentage of filler having a sphericity of 0.7 or higher in second filler | | | | | | 1 | 1 | | 1 | | 1 | | 1 | 1 | | 1 | | 1 | |
| Evaluation of resin composition | Viscosity (Pa·s) | | | | | 480 | 413 | | 182 | | 614 | | 530 | 499 | | 142 | | 118 | |
| | Thermal conductivity (W/(m·K)) | | | | | 13.2 | 11 | | 8.2 | | 13.8 | | 17.4 | 10.2 | | 7.4 | | 7.1 | |
| | Flow rate (g/min) | | | | | 38 | 62 | | 138 | | 10.5 | | 32.9 | 18.9 | | 263 | | 350 | |
| Evaluation score | Thermal conductivity (score points) | | | | | 10 | 7 | | 1 | | 10 | | 10 | 6 | | 0 | | 0 | |
| | Flow rate (score points) | | | | | 4 | 7 | | 10 | | 2 | | 4 | 2 | | 10 | | 10 | |
| | Thermal conductivity + Flow rate (score points) | | | | | 14 | 14 | | 11 | | 12 | | 14 | 8 | | 10 | | 10 | |

[Table 5]

| | | | Density (g/cc) | Sphericity | Volume-average particle diameter (μm) | Comparative Example 4 | | Comparative Example 5 | | Comparative Example 6 | | Comparative Example 7 | | Comparative Example 8 | | Comparative Example 9 | | Comparative Example 10 | | Comparative Example 11 | |
|---|---|---|---|---|---|---|---|---|---|---|---|---|---|---|---|---|---|---|---|---|---|
| | | | | | | first component | second component | first component | second component | first component | second component | first component | second component | first component | second component | first component | second component | first component | second component | first component | second component |
| Kind of first filler | | | | | | aluminum nitride | aluminum nitride | crushed diamond | crushed diamond | polyhedral alumina | polyhedral alumina | AG diamond | AG diamond | AG diamond | AG diamond | AG diamond | AG diamond | AG diamond | AG diamond | AG diamond | AG diamond |
| Kind of second filler | | | | | | alumina | alumina | alumina | alumina | alumina | alumina | AG diamond | AG diamond | aluminum nitride/alumina | aluminum nitride/alumina | alumina | alumina | alumina | alumina | alumina | alumina |
| Volume percentage (% by volume) | Whole of fillers | | | | | 85 | 85 | 85 | 85 | 85 | 85 | 85 | 85 | 85 | 85 | 85 | 85 | 85 | 85 | 85 | 85 |
| | First filler | | | | | - | - | - | - | - | - | 85 | 85 | 24.4 | 24.4 | 17.7 | 17.7 | 39.8 | 39.8 | 56.1 | 56.1 |
| | Diamond | | | | | - | - | 40.4 | 40.4 | - | - | 85 | 85 | 24.4 | 24.4 | 17.7 | 17.7 | 39.8 | 39.8 | 56.1 | 56.1 |
| | Second filler | | | | | 85 | 85 | 85 | 85 | 85 | 85 | - | - | 60.6 | 60.6 | 67.3 | 67.3 | 45.2 | 45.2 | 28.9 | 28.9 |
| | Aluminum nitride | | | | | 59.5 | 59.5 | - | - | - | - | - | - | 47.8 | 47.8 | - | - | - | - | - | - |
| | Matrix resin | | | | | 9 | 9 | 9 | 9 | 9 | 9 | 9 | 9 | 9 | 9 | 9 | 9 | 9 | 9 | 9 | 9 |
| | Dispersant | | | | | 6 | 6 | 6 | 6 | 6 | 6 | 6 | 6 | 6 | 6 | 6 | 6 | 6 | 6 | 6 | 6 |
| Formulation (parts by mass) | | Matrix resin | 0.97 | | | 2.34 | 2.34 | 2.331 | 2.331 | 2.331 | 2.331 | 2.448 | 2.448 | 2.238 | 2.238 | 2.106 | 2.106 | 2.304 | 2.304 | 1.968 | 1.968 |
| | | Kind of resin | | | | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 | silicone resin 1 | silicone resin 2 |
| | | Dispersant | 0.97 | | | 1.56 | 1.56 | 1.554 | 1.554 | 1.554 | 1.554 | 1.632 | 1.632 | 1.492 | 1.492 | 1.404 | 1.404 | 1.536 | 1.536 | 1.312 | 1.312 |
| | | Kind of dispersant | | | | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 | dispersant 1 |
| | Zinc oxide | zinc oxide 1 | 5.78 | 0.6 | 0.42 | | | | | | | | | | | | | | | | |
| | Alumina | alumina 1 | 3.94 | 0.8 | 0.32 | 7 | 7 | 7 | 7 | 7 | 7 | | | 6 | 6 | 7 | 7 | 7 | 7 | 7 | 7 |
| | | alumina 2 | 3.94 | 0.8 | 0.58 | 5 | 5 | 5 | 5 | 5 | 5 | | | 7 | 7 | 5 | 5 | 5 | 5 | 5 | 5 |
| | | alumina 3 | 3.94 | 0.8 | 1.7 | | | | | | | | | | | | | | | | |
| | | alumina 4 | 3.94 | 0.8 | 6.6 | 15 | 15 | 13 | 13 | 13 | 13 | | | | | 20 | 20 | 15 | 15 | 15 | 15 |
| | | alumina 5 | 3.94 | 0.8 | 20.3 | | | 22 | 22 | 22 | 22 | | | | | 32 | 32 | 20 | 20 | 10 | 10 |
| | Polyhedral alumina | polyhedral alumina 1 | 3.94 | 0.8 | 32.0 | | | | | 42.5 | 42.5 | | | | | | | | | | |
| | Aluminum nitride | aluminum nitride 1 | 3.26 | 0.7 | 1.0 | | | | | | | | | | | | | | | | |
| | | aluminum nitride 2 | 3.26 | 0.7 | 4.7 | | | | | | | | | | | | | | | | |
| | | aluminum nitride 3 | 3.26 | 0.7 | 18.3 | | | | | | | | | | | | | | | | |
| | | aluminum nitride 4 | 3.26 | 0.95 | 37.0 | 17 | 17 | | | | | | | | | | | | | | |
| | | aluminum nitride 5 | 3.26 | 0.95 | 78.0 | 35 | 35 | | | | | | | | | | | | | | |
| | | aluminum nitride 6 | 3.26 | 0.7 | 98.0 | | | | | | | | | 40 | 40 | | | | | | |
| | Crushed diamond | crushed diamond 1 | 3.52 | 0.6 | 69.5 | | | 38 | 38 | | | | | | | | | | | | |
| | AG diamond | As-Grown diamond 1 | 3.52 | 0.9 | 9.9 | | | | | | | 27 | 27 | | | | | | | | |
| | | As-Grown diamond 2 | 3.52 | 0.9 | 18.6 | | | | | | | | | | | | | | | | |
| | | As-Grown diamond 3 | 3.52 | 0.9 | 23.0 | | | | | | | | | | | | | | | 10 | 10 |
| | | As-Grown diamond 4 | 3.52 | 0.9 | 34.0 | | | | | | | 20 | 20 | 7 | 7 | | | | | | |
| | | As-Grown diamond 5 | 3.52 | 0.9 | 48.9 | | | | | | | | | | | | | 37 | 37 | 30 | 30 |
| | | As-Grown diamond 6 | 3.52 | 0.9 | 68.3 | | | | | | | 37 | 37 | 15 | 15 | 15 | 15 | | | | |
| | | As-Grown diamond 7 | 3.52 | 0.9 | 118.5 | | | | | | | | | | | | | | | | |
| Volume-average particle diameter for primary particle | Volume-average particle diameter of first filler (μm) | | | | | 65.2 | | 69.5 | | 28.7 | | 59.7 | | 60.2 | | 68.3 | | 48.9 | | 43.9 | |
| | Volume-average particle diameter of second filler (μm) | | | | | 6.4 | | 18.5 | | 18.5 | | 9.9 | | 99.5 | | 17.1 | | 18.5 | | 13.2 | |
| | Ratio of volume-average particle diameters (second filler/first filler) | | | | | 0.098 | | 0.266 | | 0.645 | | 0.166 | | 1.653 | | 0.250 | | 0.378 | | 0.301 | |
| Volume percentage of filler having a sphericity of 0.7 or higher in second filler | | | | | | 1 | | 0.45 | | 1 | | 1 | | 1 | | 1 | | 1 | | 1 | |
| Evaluation of resin composition | Viscosity (Pa·s) | | | | | 730 | | 653 | | no compound could be made | | no compound could be made | | no compound could be made | | 643 | | 634 | | 587 | |
| | Thermal conductivity (W/(m·K)) | | | | | 10.4 | | 9.9 | | | | | | | | 8.7 | | 10.6 | | 10.9 | |
| | Flow rate (g/min) | | | | | 14.3 | | 28.3 | | | | | | | | 18.7 | | 29.4 | | 25.8 | |
| Evaluation score | Thermal conductivity (score points) | | | | | 6 | | 5 | | | | | | | | 3 | | 7 | | 7 | |
| | Flow rate (score points) | | | | | 2 | | 3 | | | | | | | | 2 | | 3 | | 3 | |
| | Thermal conductivity + Flow rate (score points) | | | | | 8 | | 8 | | | | | | | | 5 | | 10 | | 10 | |

Note: Since Comparative Examples 1, 4, 5, 6 contained no first filler, the volume-average particle diameter of aluminum nitride, polyhedral alumina, or crushed diamond is indicated as the volume-average particle diameter of the first filler, and the volume-average particle diameter of a filler other than these is indicated as the volume-average particle diameter of the second filler.

As shown in Tables 2 to 5, the resin composition of each Example had the first filler composed of at least either of octahedral diamond and hexoctahedral diamond, and the second filler other than the first filler; and the volume-average

particle diameter for primary particle diameter of the first filler was larger than that of the second filler, and was 55 μm or larger. Then, the volume percentage of the whole of the fillers was 80% by volume or higher and the volume percentage of the diamond was 20% by volume or higher. Due to that the resin composition of each Example had the above constitution, the total point of the evaluate score became high and both of the heat dissipation performance and the flowability could be attained.

By contrast, since Comparative Examples 1, 4, 5 contains no octahedral diamond and hexoctahedral diamond, the total point of the evaluation score was low, and both of the heat dissipation performance and the flowability could not be attained. Then, Comparative Example 6 used no octahedral diamond and hexoctahedral diamond and used polyhedral alumina in place of these, but the fillers were not sufficiently dispersed in the matrix resin, and no compound could be made. Since in Comparative Example 7, no second filler was contained, and in Comparative Example 8, the volume-average particle diameter of the second filler was too large, the fillers were similarly not sufficiently dispersed in the matrix resin, and no compound could be made.

Then, as shown in Comparative Examples 2, 3, when the volume percentage of the whole of the fillers was low, the heat dissipation performance was not sufficiently improved; and as shown in Comparative Example 9, when the volume percentage of the diamond was low, both of the heat dissipation performance and the flowability could not be attained. Further, as shown in Comparative Examples 10, 11, even when octahedral diamond or hexoctahedral diamond was used, when the volume-average particle diameter thereof was small, both of the heat dissipation performance and the flowability could not be sufficiently attained.

## Claims

1. A resin composition, comprising:

   a first filler that is at least one selected from the group consisting of octahedral diamond and hexoctahedral diamond;
   a second filler different from the first filler; and
   a matrix resin,
   a volume-average particle diameter for primary particle diameter of the first filler being larger than a volume-average particle diameter for primary particle diameter of the second filler;
   a volume percentage of a whole of fillers therein being higher than 80% by volume, and a volume percentage of diamond therein being higher than 20% by volume; and
   the volume-average particle diameter for primary particle diameter of the first filler being 55 μm or larger.

2. The resin composition according to claim 1, wherein the second filler comprises at least one selected from the group consisting of nitrides and metal oxides.

3. The resin composition according to claim 1, wherein the second filler comprises at least one selected from the group consisting of aluminum oxide and aluminum nitride.

4. The resin composition according to claim 3, wherein the second filler comprises aluminum nitride.

5. The resin composition according to any one of claims 1 to 4, wherein a ratio of the volume-average particle diameter for primary particle diameter of the second filler to the volume-average particle diameter for primary particle diameter of the first filler is 0.005 or higher and 0.5 or lower.

6. The resin composition according to any one of claims 1 to 4, wherein the second filler comprises at least a filler having a sphericity of 0.7 or higher.

7. The resin composition according to any one of claims 1 to 4, wherein the volume percentage of the whole of the fillers therein is 85% by volume or higher.

8. The resin composition according to any one of claims 1 to 4, wherein the volume percentage of the diamond therein is 20% by volume or higher and 70% by volume or lower.

9. The resin composition according to any one of claims 1 to 4, wherein the volume percentage of the diamond therein is 30% by volume or higher and 65% by volume or lower.

**10.** The resin composition according to any one of claims 1 to 4, wherein the matrix resin is at least one selected from the group consisting of a silicone resin, an epoxy resin and an acrylic resin.

**11.** The resin composition according to any one of claims 1 to 4, further comprising a dispersant.

**12.** The resin composition according to claim 11, wherein the dispersant is a silicone compound having a polar group on an end or a side chain thereof.

**13.** The resin composition according to claim 12, wherein the silicone compound has at least either of an alkoxy group and a hydroxyl group on an end thereof.

**14.** The resin composition according to any one of claims 1 to 4, wherein the resin composition has a viscosity at 25°C of 700 Pa·s or lower and a thermal conductivity of 10 W/(m·K) or higher.

**15.** A heat-dissipating member, being formed of the resin composition according to any one of claims 1 to 4.

**16.** An electronic device, comprising an electronic component, and the heat-dissipating member according to claim 15 disposed on the electronic component.

## INTERNATIONAL SEARCH REPORT

International application No.
**PCT/JP2024/002455**

**A. CLASSIFICATION OF SUBJECT MATTER**

***C08L 101/00***(2006.01)i; ***C08K 3/04***(2006.01)i; ***C08K 3/013***(2018.01)i; ***C08K 3/22***(2006.01)i; ***C08K 3/28***(2006.01)i; ***C08K 5/54***(2006.01)i; ***C08K 7/18***(2006.01)i; ***C08L 33/00***(2006.01)i; ***C08L 63/00***(2006.01)i; ***C08L 83/04***(2006.01)i; ***C09K 5/14***(2006.01)i
FI: C08L101/00; C08K3/013; C08K3/04; C08K3/22; C08K3/28; C08L33/00; C08L63/00 C; C08L83/04; C08K5/54; C08K7/18; C09K5/14 E

According to International Patent Classification (IPC) or to both national classification and IPC

**B. FIELDS SEARCHED**

Minimum documentation searched (classification system followed by classification symbols)

C08L101/00; C08K3/04; C08K3/013; C08K3/22; C08K3/28; C08K5/54; C08K7/18; C08L33/00; C08L63/00; C08L83/04; C09K5/14

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2019-89957 A (SEKISUI CHEMICAL CO., LTD.) 13 June 2019 (2019-06-13) | 1-16 |
| A | JP 2018-111817 A (SEKISUI CHEMICAL CO., LTD.) 19 July 2018 (2018-07-19) | 1-16 |
| A | JP 2004-165459 A (ISHIZUKA KENKYUSHO KK) 10 June 2004 (2004-06-10) | 1-16 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 March 2024** | **26 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/002455**

| Patent document cited in search report | Publication date (day/month/year) | Patent family member(s) | Publication date (day/month/year) |
|---|---|---|---|
| JP 2019-89957 A | 13 June 2019 | (Family: none) | |
| JP 2018-111817 A | 19 July 2018 | (Family: none) | |
| JP 2004-165459 A | 10 June 2004 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 7039157 B
- WO 2019230969 A